(19) Europäisches Patentamt
European Patent Office
Office européen des brevets

(11) **EP 2 523 218 A2**

(12) **EUROPEAN PATENT APPLICATION**

(43) Date of publication:
**14.11.2012 Bulletin 2012/46**

(51) Int Cl.:
**H01L 31/0352** (2006.01)

(21) Application number: **12166420.5**

(22) Date of filing: **02.05.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.05.2011 JP 2011104591**
**24.05.2011 JP 2011115876**

(71) Applicant: **Sharp Kabushiki Kaisha**
**Osaka-shi, Osaka 545-8522 (JP)**

(72) Inventors:
• **Yoshikawa, Hirofumi**
  **Osaka-shi, Osaka 545-8522 (JP)**
• **Izumi, Makoto**
  **Osaka-shi, Osaka 545-8522 (JP)**
• **Kuzumoto, Yasutaka**
  **Osaka-shi, Osaka 545-8522 (JP)**

(74) Representative: **Treeby, Philip David William et al**
**R.G.C. Jenkins & Co**
**26 Caxton Street**
**London**
**Greater London SW1H 0RJ (GB)**

(54) **Solar Cell**

(57) A solar cell comprises a p-type semiconductor layer, an n-type semiconductor layer, and a superlattice semiconductor layer interposed between the p-type semiconductor layer and the n-type semiconductor layer, wherein the superlattice semiconductor layer has a stacked structure in which quantum layers and barrier layers are stacked alternately and repeatedly, wherein the stacked structure is formed whereby a miniband is formed by a quantum level of the quantum layers on the side of a conduction band, wherein an energy level at a bottom of the miniband is lower than an energy level at a bottom of the conduction band of the barrier layers, and an energy level at a top of the miniband is higher than an energy level, which is lower than the energy level at the bottom of the conduction band of the barrier layers by an amount twice as much as thermal energy at room temperature.

FIG. 1

EP 2 523 218 A2

**Description**

**CROSS-REFERENCE TO RELATED APPLICATION**

This application is related to Japanese Patent Application Nos. 2011-104591 filed on May 9, 2011 and 2011-115876 filed on May 24, 2011, whose priorities are claimed under 35 USC §119, and the disclosures of which are incorporated by reference in its entirety.

**BACKGROUND OF THE INVENTION**

1. Field of the Invention

The present invention relates to a solar cell having a superlattice structure.

2. Description of the Related Art

Research and development on solar cells has been carried out in various directions in order to utilize light in a wider wavelength range and enhance photoelectric conversion efficiency. For example, there has been proposed a solar cell that can utilize light of a longer wavelength by exciting electrons in two steps with an intermediate band provided between a valence band and a conduction band by a quantum dot technique (for example, Physical Review Letters, vol. 97, 2006, page 247701).

Physical Review Letters, vol. 97, 2006, page 247701, and National Publication of Japanese Translation of PCT Application No. 2010-509772 describe an intermediate-band solar cell that has a tunnel barrier and includes plural quantum dots embedded into an inorganic matrix, and an intermediate-band solar cell including quantum dots embedded into an energy fence barrier.

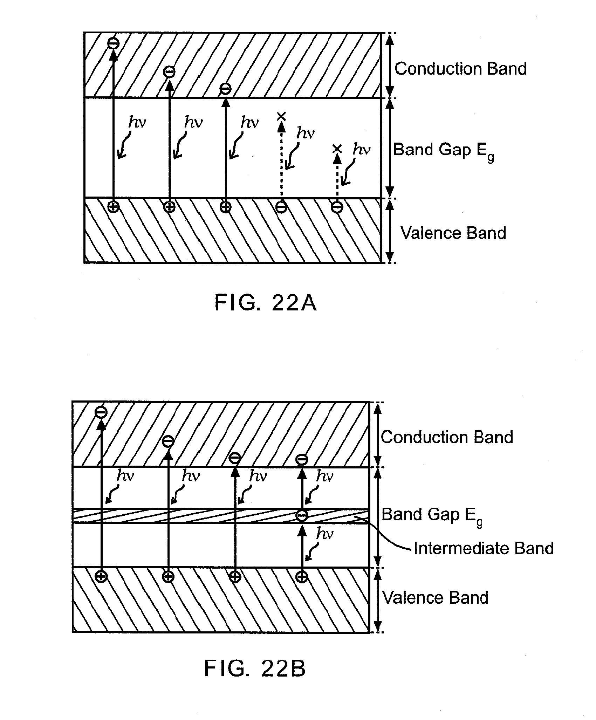

The intermediate-band solar cell including the quantum dots described above is formed by inserting the superlattice semiconductor layer including the quantum dot layers into a compound solar cell as an i-type layer. In the intermediate-band solar cell having the quantum dots, the superlattice semiconductor layer including the quantum dot layers is inserted into the matrix semiconductor material, whereby an intermediate band is formed in the thickness direction of the superlattice semiconductor layer due to an electronic coupling between the quantum dots as illustrated in Fig. 22B. The two-step optical excitation through the intermediate band allows absorption of photons, which have energy smaller than the bandgap of the matrix materials, and which cannot be absorbed by a general solar cell illustrated in fig. 22A.

The carriers generated from the photons are transferred through the intermediate band and the conduction band or the valence band, and they can be extracted from p-type and n-type semiconductor regions.

Specifically, it is considered that the intermediate-band solar cell having the quantum dots can extract light of a wavelength range that has not been utilized by a general solar cell as electric current through photoelectric conversion, so that the intermediate-band solar cell can increase short-circuit current density more than the general solar cell.

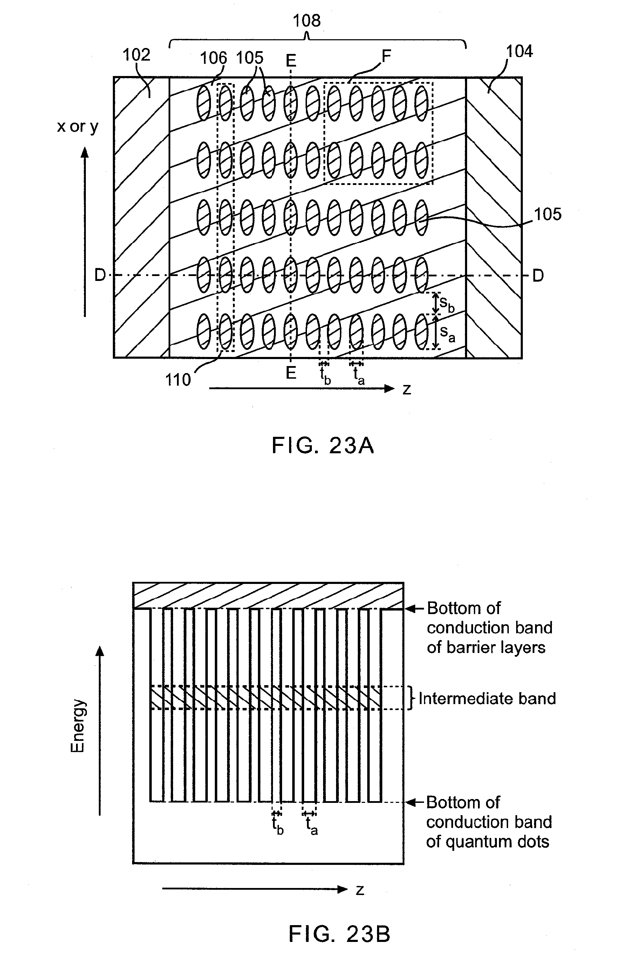

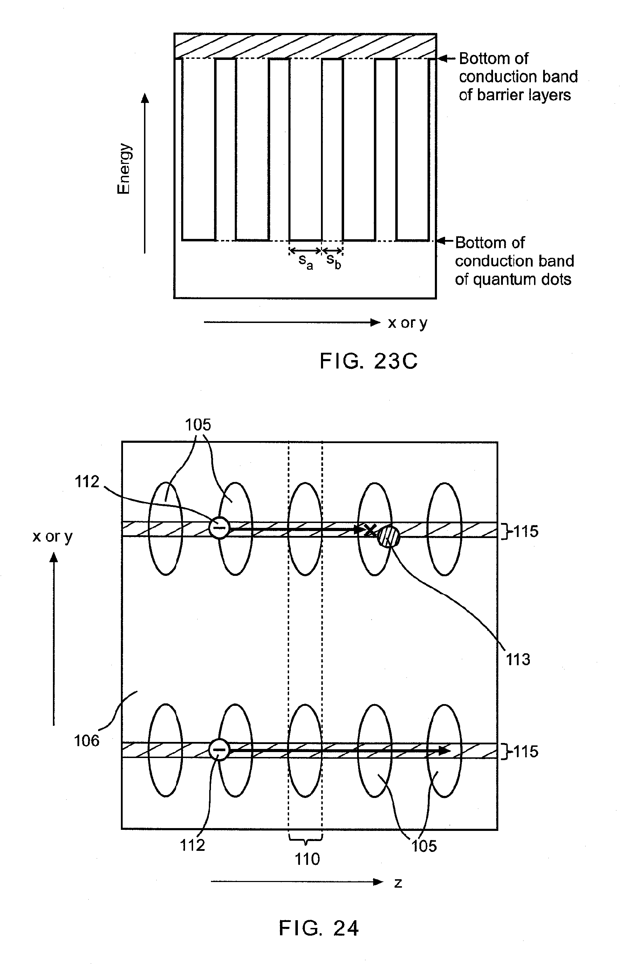

Fig. 23A is a schematic cross-sectional view illustrating a conventional solar cell including quantum dots in the vicinity of a superlattice semiconductor layer, Fig. 23B is a schematic band diagram illustrating an energy level of the superlattice semiconductor layer in a conduction band along a chain line D - D in Fig. 23A, and Fig. 23C is a schematic band diagram illustrating an energy level of the superlattice semiconductor layer in a conduction band along a dotted line E - E in Fig. 23A. In Figs. 23B and 23C, an internal electric field generated by a p-i-n junction is neglected. Figs. 23B and 23C illustrate only quantum levels of quantum dots 105 by which the intermediate band is formed. A band where electrons can be present is indicated by a hatched line in Figs. 23B and 23C.

Fig. 24 is an enlarged cross-sectional view of a region F, enclosed by a dotted line, in the superlattice semiconductor layer in Fig. 23A, and it is an explanatory view for describing electrons transferring through the intermediate band.

The conventional solar cell including the quantum dots includes a p-type semiconductor layer 102, an n-type semiconductor layer 104, and a superlattice semiconductor layer 108 interposed between the p-type semiconductor layer 102 and the n-type semiconductor layer 104, wherein the superlattice semiconductor layer 108 has a structure in which quantum dot layers 110 including quantum dots 105 and barrier layers 106 are stacked alternately and repeatedly, as illustrated in Fig. 23A.

As illustrated in Figs. 23A, 23B, and 23C, the quantum dots 105 each included in the solar cell is a mircroparticle made of a material having a bandgap narrower than a bandgap of a material for the barrier layers 106, and the conduction band in the quantum dot layers 105 is confined by the barrier layers 106 to form a quantum level.

The solar cell described above allows wave functions of quantum levels of two quantum dots, which are adjacent to each other in a z direction, to interact with each other by controlling a diameter $t_a$ of each quantum dot 105 and a space $t_b$ between two adjacent quantum dots 105 in the thickness direction (z direction) of the superlattice semiconductor layer 108, thereby forming an intermediate band in the z direction as illustrated in Fig. 23B. Therefore, electrons in the valence band can be excited to the conduction band due to the two-step optical excitation through the intermediate band. Accordingly, the solar cell can execute photoelectric conversion utilizing photons having energy smaller than the bandgap of the matrix semiconductor materials.

## SUMMARY OF THE INVENTION

In an existing quantum dot solar cell utilizing a miniband, the photocurrent extraction efficiency in the quantum dots is not more than several % at maximum. Although the reason is not obvious, this is considered due to a low probability in which the carriers generated in the quantum dots move to the p-type or n-type semiconductor region by optical excitation or thermal excitation.

In view of the above-described circumstances, the present invention has been achieved to provide a solar cell having a superlattice structure in which carriers are efficiently extracted to p-type and n-type semiconductor regions.

The present invention provides a solar cell comprising a p-type semiconductor layer, an n-type semiconductor layer, and a superlattice semiconductor layer interposed between the p-type semiconductor layer and the n-type semiconductor layer, wherein the superlattice semiconductor layer has a stacked structure in which quantum layers and barrier layers are stacked alternately and repeatedly, and the superlattice semiconductor layer is formed so that a miniband is formed by a quantum level of the quantum layers on the side of a conduction band, wherein an energy level at a bottom of the miniband is lower than an energy level at a bottom of the conduction band of the barrier layers, while an energy level at a top of the miniband is higher than an energy level, which is lower than the energy level at the bottom of the conduction band of the barrier layers by an amount twice as much as thermal energy kT (k: Boltzmann constant, T: absolute temperature) at room temperature.

According to the present invention, the superlattice semiconductor layer has a stacked structure for forming the miniband by the quantum level of the quantum layers on the side of the conduction band, and the energy level at the bottom of the miniband is lower than the energy level at the bottom of the conduction band of the barrier layers. Therefore, carriers, which are generated not only by a light transition corresponding to the bandgap of the matrix semiconductor material but also by optical energy less than the bandgap of the matrix semiconductor material utilizing the miniband, can efficiently be extracted from the p-type semiconductor layer or n-type semiconductor layer, whereby photocurrent can be increased.

According to the present invention, the energy level at the top of the miniband is higher than an energy level, which is lower than the energy level at the bottom of the conduction band of the barrier layers by an amount twice as much as the thermal energy kT (k: Boltzmann constant, T: absolute temperature) at room temperature. Therefore, the probability of the electrons in the miniband being thermally excited to the conduction band of the barrier layers can be made as 10% or more according to Fermi distribution function at room temperature, whereby carriers generated in the superlattice semiconductor layer can efficiently be extracted. Accordingly, short-circuit current can drastically be increased. By virtue of this, the present invention can provide a solar cell having high photoelectric conversion efficiency.

## BRIEF DESCRIPTION OF THE DRAWINGS

Fig. 1 is a schematic cross-sectional view illustrating a configuration of a solar cell according to an embodiment of the present invention;

Fig. 2 is a schematic band diagram illustrating an energy level of a superlattice semiconductor layer in a conduction band along a chain line A - A in Fig. 1;

Fig. 3 is a graph illustrating a dispersion relation, obtained by a simulation in Experiment 1, in the conduction band of the superlattice semiconductor layer;

Fig. 4 is a graph illustrating a dispersion relation, obtained by the simulation in Experiment 1, in a valence band (heavy holes) of the superlattice semiconductor layer;

Fig. 5 is a graph illustrating a dispersion relation, obtained by the simulation in Experiment 1, in a valence band (light holes) of the superlattice semiconductor layer;

Fig. 6 is a graph illustrating a dispersion relation, obtained by a simulation in Experiment 2, in the conduction band of the superlattice semiconductor layer;

Fig. 7 is a graph illustrating a dispersion relation, obtained by a simulation in Experiment 3, in the conduction band of the superlattice semiconductor layer;

Fig. 8 is a graph illustrating a dispersion relation, obtained by a simulation in Experiment 4, in the conduction band of the superlattice semiconductor layer;

Fig. 9A is a schematic cross-sectional view illustrating a superlattice semiconductor layer and other layers included in the solar cell according to an embodiment of the present invention;

Fig. 9B is a schematic band diagram illustrating an energy level of the superlattice semiconductor layer in the conduction band along a chain line A - A in Fig. 9A;

Fig. 9C is a schematic band diagram illustrating an energy level of the superlattice semiconductor layer in the conduction band along a dotted line B - B in Fig. 9A;

Fig. 10 is an enlarged cross-sectional view of a region C, enclosed by a dotted line in Fig. 9A, in the superlattice semiconductor layer, and is an explanatory view for describing electrons transferring through an intermediate band;

Fig. 11 is a schematic cross-sectional view illustrating a solar cell according to an embodiment of the present invention;

Fig. 12 is a graph illustrating a result calculated in a simulation experiment;

Fig. 13 is a graph illustrating a result calculated in the simulation experiment;

Fig. 14 is a graph illustrating a relationship between $r_a$ and $r_b$ calculated in the simulation experiment;

Fig. 15 is a graph illustrating a result calculated in the simulation experiment;

Fig. 16 is a graph illustrating a result calculated in the simulation experiment;

Fig. 17 is a graph illustrating a relationship between $r_a$ and $r_b$ calculated in the simulation experiment;

Fig. 18 is a graph illustrating a result calculated in the simulation experiment;

Fig. 19 is a graph illustrating a result calculated in the simulation experiment;

Fig. 20 is a graph illustrating a relationship between $r_a$ and $r_b$ calculated in the simulation experiment;

Fig. 21 is a graph collectively illustrating relationships between $r_a$ and $r_b$ calculated in the simulation experiment;

Fig. 22A is a schematic band diagram of a conventional general solar cell;

Fig. 22B is a schematic band diagram of an intermediate-band solar cell;

Fig. 23A is a schematic cross-sectional view illustrating a superlattice semiconductor layer and other layers included in a conventional intermediate-band solar cell;

Fig. 23B is a schematic band diagram illustrating an energy level of a superlattice semiconductor layer in a conduction band along a chain line D - D in Fig. 23A;

Fig. 23C is a schematic band diagram illustrating an energy level of a superlattice semiconductor layer in a conduction band along a dotted line E - E in Fig. 23A; and

Fig. 24 is an enlarged cross-sectional view of a region F, enclosed by a dotted line, in the superlattice semiconductor layer in Fig. 23A, and is an explanatory view for describing electrons transferring through an intermediate band.

## DETAILED DESCRIPTION OF THE PREFERRED EMBODIMENTS

The solar cell according to the present invention comprises a p-type semiconductor layer, an n-type semiconductor layer, and a superlattice semiconductor layer interposed between the p-type semiconductor layer and the n-type semiconductor layer, wherein the superlattice semiconductor layer has a stacked structure in which quantum layers and barrier layers are stacked alternately and repeatedly, and the superlattice semiconductor layer is formed so that a miniband is formed by a quantum level of the quantum layers on the side of a conduction band, wherein an energy level at a bottom of the miniband is lower than an energy level at a bottom of the conduction band of the barrier layers, while an energy level at a top of the miniband is higher than an energy level, which is lower than the energy level at the bottom of the conduction band of the barrier layers by an amount twice as much as thermal energy kT (k: Boltzmann constant, T: absolute temperature) at room temperature.

The terms often used in the present specification will be described with additional explanation.

The superlattice structure means a structure obtained by repeating a stack of two different layers, each being made of a semiconductor, and having a different bandgap, wherein the electron wave function of a layer having a small bandgap and the electron wave function of an adjacent layer having a large bandgap greatly interact. The layer having the large bandgap is referred to as a barrier layer, while the layer with the small bandgap is referred to as a well layer. The well layer includes a quantum dot layer and a quantum layer.

The miniband (intermediate band) means a band formed due to resonant tunneling effect produced between quantum levels of adjacent quantum wells or quantum dots as a result of the interaction between electron wave functions of the adjacent quantum wells or adjacent quantum dots in the superlattice structure. The miniband (intermediate band) means a band in which at least a part thereof is formed between a top of a valence band and a bottom of a conduction band of the barrier layer. In the present invention, the case where the width of the intermediate band is not less than 26 meV that corresponds to a thermal energy at room temperature is defined as the state where the intermediate band is formed. A solar cell is generally used at room temperature or higher temperature. Therefore, if the width of the intermediate band is 26 meV or more, carriers can move through the intermediate band under a general operating condition of a solar cell.

The quantum dots mean semiconductor microparticles having a particle size of 100 nm or less, surrounded with a semiconductor having a bandgap wider than that of the semiconductor forming the quantum dots.

The quantum dot layer means a layer including a plurality of quantum dots, being a well layer having a superlattice structure.

The quantum level means a discrete electronic energy level of a quantum dot.

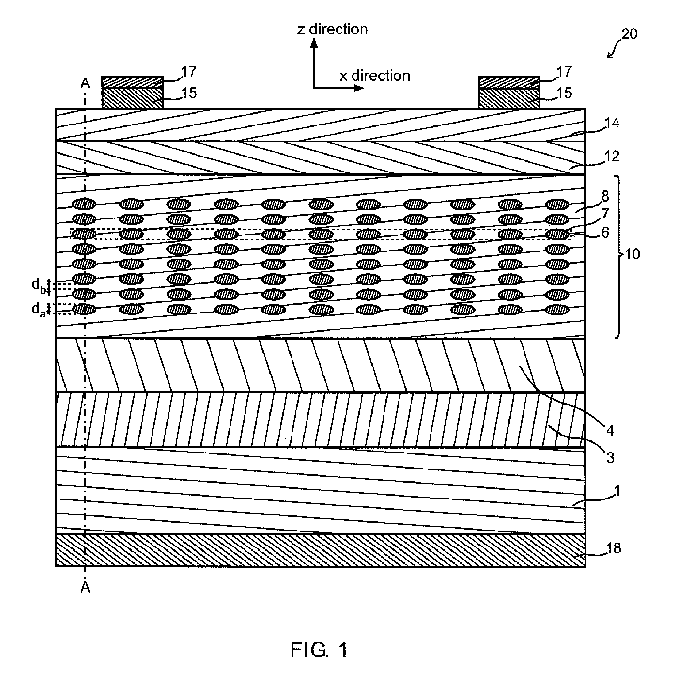

An x direction is a direction parallel to the stacked surface as illustrated in Fig. 1, a y direction is a direction parallel to the stacked surface, and vertical to the x direction. A z direction is a direction vertical to the stacked surface as illustrated in Fig. 1.

Preferably, in the solar cell according to the present invention, the energy level at the top of the miniband is higher than the energy level at the bottom of the conduction band of the barrier layers.

According to this configuration, the electrons in the miniband can easily move to the conduction band of the barrier layers, whereby the carriers generated in the superlattice semiconductor layer can efficiently be extracted to the outside.

Preferably, in the solar cell of the present invention, the superlattice semiconductor layer is formed so that only one miniband is formed by the quantum level of the quantum layers on the side of the conduction band.

This configuration prevents the relaxation between the minibands, the relaxation being generated if there are plural minibands. Therefore, the carriers generated in the superlattice semiconductor layer can efficiently be extracted through the p-type semiconductor layer or the n-type semiconductor layer.

Preferably, in the solar cell according to the present invention, the p-type semiconductor layer, the n-type semiconductor layer, and the superlattice semiconductor layer form a p-n junction or p-i-n junction.

This configuration can effectively produce electromotive force when the p-i-n junction or the p-n junction is subjected to light.

Preferably, in the solar cell according to the present invention, the quantum layer is a quantum dot layer including plural quantum dots.

According to this configuration, the energy level of the miniband can easily be changed due to the quantum effect of the quantum dots. This configuration can also easily form the miniband in which the energy level at the bottom of the miniband is lower than the energy level at the bottom of the conduction band of the barrier layers, while the energy level at the top of the miniband is higher than the energy level, which is lower than the energy level at the bottom of the conduction band of the barrier layers by an amount twice as much as the thermal energy at room temperature.

Preferably, in the solar cell according to the present invention, the superlattice semiconductor layer is preferably made of a group III-V compound semiconductor, a group II-VI compound semiconductor or a chalcopyrite semiconductor.

According to such a configuration, the miniband is easily formed on the superlattice semiconductor layer, and the position of the miniband can easily be adjusted.

Preferably, in the solar cell according to the present invention, the superlattice semiconductor layer is preferably made of a group III-V compound semiconductor including at least one element of Al, Ga and In, and at least one element of As, Sb and P.

According to such a configuration, the miniband is easily formed on the superlattice semiconductor layer, and the position of the miniband can easily be adjusted.

The present invention also provides a solar cell comprising a p-type semiconductor layer, an n-type semiconductor layer, and a superlattice semiconductor layer interposed between the p-type semiconductor layer and the n-type semiconductor layer, wherein the superlattice semiconductor layer has a stacked structure in which barrier layers and quantum dot layers, each quantum dot layer comprising quantum dots surrounded by the barrier layers, are stacked alternately and repeatedly, wherein the stacked structure is formed whereby an intermediate band is formed in both a thickness direction of the superlattice semiconductor layer and a direction orthogonal to the thickness direction of the superlattice semiconductor layer.

A conventional intermediate-band solar cell including quantum dots has a problem of reduced density of short-circuit current actually outputted. Although the reason is not obvious, it is considered that a carrier trap such as a defect is present in the intermediate band serving as a path for carriers.

The present invention is accomplished in view of the above-mentioned circumstance, and aims to provide a solar cell that can output current with large short-circuit current density.

According to the present invention, the intermediate band can be formed in both the thickness direction of the superlattice semiconductor layer and the direction (in-plane direction of the quantum dot layers) orthogonal to the thickness direction of the superlattice semiconductor layer. Therefore, electrons excited in the intermediate band can be transferred in both the thickness direction of the superlattice semiconductor layer and the direction orthogonal to the thickness direction of the superlattice semiconductor layer. Accordingly, the electrons excited in the intermediate band are transferred in the thickness direction of the superlattice semiconductor layer due to the internal electric field, and can also be transferred in the direction orthogonal to the thickness direction of the superlattice semiconductor layer due to a phonon scattering. Consequently, even if a carrier trap such as a defect is present in the intermediate band, the electrons moving through the intermediate band can avoid the trap, whereby the probability in which the electrons moving in the intermediate band are excited in the conduction band can be increased. As a result, the number of the electrons excited in the conduction band through the intermediate band can be increased, whereby the density of the short-circuit current outputted from the solar cell can be increased.

Preferably, in the solar cell according to the present invention, the superlattice semiconductor layer has a stacked structure by which the intermediate band is formed in the direction orthogonal to the thickness direction of the superlattice semiconductor layer by the first quantum level of the quantum dots.

Some of the carriers present on the second or higher quantum level have energy reduced to the first quantum level due to relaxation. Therefore, if the intermediate band in the in-plane direction (the direction orthogonal to the thickness direction of the superlattice semiconductor layer) is formed for the first quantum level, the carriers whose energy is reduced to the first quantum level from the second or higher quantum level can efficiently be transferred through the intermediate band in the in-plane direction. Accordingly, if the intermediate band in the in-plane direction of the quantum dot layers is formed for the first quantum level, the carriers can efficiently be extracted as current.

Preferably, in the solar cell according to the present invention, the barrier layers are made of GaAs, and the quantum dot layers are made of $In_xGa_{1-x}As$ ($0 \leq x \leq 1$).

When GaAs having the bandgap of about 1.42 eV is used for the barrier layers, photovoltaic power of the solar cell can sufficiently be increased. When $In_xGa_{1-x}As$ having the bandgap narrower than the bandgap of GaAs is used for the quantum dots, the electrons in the quantum dots can be confined in a three-dimensional manner. Therefore, this configuration can produce a quantum size effect, whereby the intermediate band can be formed.

The quantum dots can be grown in an S-K mode in the crystal growth of $In_xGa_{1-x}As$ due to the difference in the lattice constant between GaAs and $In_xGa_{1-x}As$, whereby the quantum dots can easily be formed.

Preferably, in the solar cell according to the present invention, the quantum dot layers satisfy the condition in which $3.2 \ln(r_a) + r_b$ is 8.9 or less, wherein a diameter of each of the quantum dots in the direction orthogonal to the thickness direction of the superlattice semiconductor layer is defined as $r_a$, and the distance between two adjacent quantum dots in the direction orthogonal to the thickness direction of the superlattice semiconductor layer is defined as $r_b$.

In the solar cell using the barrier layers made of GaAs and the quantum dot layers made of $In_xGa_{1-x}As$, the range of x by which the effect of the solar cell can satisfactorily be exhibited is $0.4 \leq x \leq 1.0$.

On the other hand, during the formation of the quantum dot layers made of $In_xGa_{1-x}As$, there is a small variation in the composition. This condition is a condition by which the intermediate band is formed over the range of $0.4 \leq x \leq 1.0$, even if there is a variation in the composition of the quantum dots in the intermediate-band solar cell including the barrier layers made of GaAs and the quantum dots made of $In_xGa_{1-x}As$. Therefore, there is no need to consider the possibility that the formation of the intermediate band is inhibited by the variation in the composition. Accordingly, the superlattice semiconductor layer can be formed over the range of $0.4 \leq x \leq 1.0$ according to a simple design and a production method without the consideration of the influence of the variation in the composition.

Preferably, in the solar cell according to the present invention, the quantum dot layers satisfy the condition in which $2.6 \ln(r_a) + r_b$ is 8.4 or less, wherein a diameter of each of the quantum dots in the direction orthogonal to the thickness direction of the superlattice semiconductor layer is defined as $r_a$, and the distance between two adjacent quantum dots in the direction orthogonal to the thickness direction of the superlattice semiconductor layer is defined as $r_b$.

In the intermediate-band solar cells including the barrier layers made of GaAs and the representative quantum dots that are made of $In_xGa_{1-x}As$, the solar cell including the quantum dots made of InAs (x = 1) is most easily manufactured. The condition in which $2.6 \ln(r_a) + rb$ is 8.4 or less is a condition by which the intermediate band is formed over the range of $0.9 \leq x \leq 1.0$, even if there is a variation in the composition of the quantum dots in the intermediate-band solar cell including the barrier layers made of GaAs and the quantum dots made of $In_xGa_{1-x}As$. In the manufacture of the InAs quantum dots that are formed most easily, the variation in the composition of the quantum dots generally falls within the range of $0.9 \leq x \leq 1.0$. Therefore, even if there is a variation in the composition, the intermediate band can be formed. Accordingly, there is no need to consider the possibility that the formation of the intermediate band is inhibited by the variation in the composition. The condition in which $2.6 \ln(r_a) + rb$ is 8.4 or less provides a wider range of the size of the quantum dot and the distance between the quantum dots than in the condition in which $3.2 \ln(r_a) + r_b$ is 8.9 or less. Therefore, the degree of freedom of selecting the parameters is large. Accordingly, the superlattice semiconductor layer can be formed according to a simple design and production method without the consideration of the influence of the variation in the composition of the InAs quantum dots that can easily be formed.

Hereinafter, first and second embodiments of the present invention will be described with reference to the drawings. Configurations shown in the drawings or the following descriptions are just exemplifications and the scope of the present invention is not limited thereto.

Configuration of solar cell according to first embodiment

Fig. 1 is a schematic cross-sectional view illustrating a configuration of a solar cell according to an embodiment of the present invention.

A solar cell 20 of the present embodiment comprises: a p-type semiconductor layer 1; an n-type semiconductor layer 12; and a superlattice semiconductor layer 10 interposed between the p-type semiconductor layer 1 and the n-type semiconductor layer 12, wherein the superlattice semiconductor layer 10 has a stacked structure in which quantum layers 6 and barrier layers 8 are stacked alternately and repeatedly, and the superlattice semiconductor layer 10 is formed so that a miniband is formed by a quantum level of the quantum layers 6 on the side of a conduction band, wherein an energy level at a bottom of the miniband is lower than an energy level at a bottom of the conduction band of the barrier layers, while an energy level at a top of the miniband is higher than an energy level, which is lower than the energy level at the bottom of the conduction band of the barrier layers by an amount twice as much as thermal energy kT (k: Boltzmann constant, T: absolute temperature) at room temperature. In Fig. 1, the quantum layers 6 are quantum dot layers. However, the quantum layers 6 may be quantum well layers.

Although the solar cell 20 of the present embodiment only necessary has the configuration described above, the quantum layers 6 may be quantum dot layers 6 including quantum dots 7. As illustrated in Fig. 1, the solar cell 20 of the present embodiment may further have a buffer layer 3, a base layer 4, a window layer 14, a contact layer 15, a p-type electrode 18 and an n-type electrode 17.

Hereinafter, the solar cell 20 of the present embodiment will be described.

1. P-type semiconductor layer and n-type semiconductor layer

The p-type semiconductor layer 1 is formed of a semiconductor including p-type impurities and can form a p-i-n junction or a p-n junction with an i-type semiconductor layer (superlattice semiconductor layer 10) and the n-type semiconductor layer 12.

The n-type semiconductor layer 12 is formed of a semiconductor including n-type impurities and can form a p-i-n junction or a p-n junction with an i-type semiconductor layer (superlattice semiconductor layer 10) and the p-type semiconductor layer 1.

The p-i-n junction or the p-n junction develops an electromotive force when subjected to light.

As illustrated in Fig. 1, the p-type semiconductor layer 1 or the n-type semiconductor layer 12 may be a substrate, and both of them may be thin films grown by a CVD method and so on.

The p-type semiconductor layer 1 or the n-type semiconductor layer 12 may have added thereto impurities corresponding to the semiconductor material same as that of the barrier layer 8, or may have added thereto impurities corresponding to a semiconductor material different from that of the barrier layer 8.

2. Superlattice semiconductor layer

The superlattice semiconductor layer 10 is interposed between the p-type semiconductor layer 1 and the n-type semiconductor layer 12, and can form a p-i-n junction or a p-n junction. The superlattice semiconductor layer 10 has a superlattice structure in which the barrier layers 8 and the quantum layers 6 are stacked alternately and repeatedly. The superlattice semiconductor layer 10 may be an i-type semiconductor layer or a semiconductor layer including p-type impurities or n-type impurities as long as development of an electromotive force is caused by light received. Examples of representative quantum layer 6 include the quantum dot layer 6, and quantum well layer. The case where the quantum layer 6 is the quantum dot layer will be described below. The same is applied to the other quantum layers.

The materials of the barrier layers 8 and the quantum dot layers 6 constituting the superlattice semiconductor layer 10 are not particularly limited, and examples thereof include a group III-V compound semiconductor. The quantum dot layers 6 are formed of a semiconductor material having a bandgap narrower than the barrier layers 8.

Besides, the materials of the barrier layers 8 and the quantum dot layers 6 constituting the superlattice semiconductor layer 10 may be AlSb, $InAs_xSb_{1-x}$, $AlSb_xAs_{1-x}$, AlAs, GaAs, $In_xGa_{1-x}As$, $Al_xGa_{1-x}As$, and $In_xGa_{1-x}P$. The materials of the barrier layers 8 and the quantum dot layers 6 may further be a group IV semiconductor in the periodic table, a compound semiconductor composed of an element of group V and an element of group III, a compound semiconductor composed of an element of group II, an element of group VI, and an element of group VII or a mixed crystal of these materials. A chalcopyrite semiconductor may also be used, and other semiconductors may also be used. For example, the material of the barrier layers 8 may be GaNAs and the material of the quantum dot layers 6 may be InAs, the material of the barrier layers 8 may be GaP and the material of the quantum dot layers 6 may be InAs, the material of the barrier layers 8 may be GaN and the material of the quantum dot layers 6 may be $Ga_xIn_{1-x}N$, the material of the barrier layers 8 may be GaAs and the material of the quantum dot layers 6 may be GaSb, the material of the barrier layers 8 may be AlAs and the material of the quantum dot layers 6 may be InAs, or the material of the barrier layers 8 may be $CuGaS_2$ and the material of the quantum dot layers 6 may be $CuInSe_2$.

Decreasing the thickness of the barrier layers 8 can cause electronic coupling between two adjacent quantum layers 6, whereby a superlattice miniband can be formed due to the quantum level of the quantum layers 6. That is, in the case of the superlattice structure including quantum dots confined in x-y direction, the wave function of the quantum dot structure is equal to the wave function of a quantum well by confinement only in the z direction. On the other hand, the energy value of the quantum dot structure can be assumed to be a sum of an energy value $E_z$ of the z direction and

energy values ($E_x$, Ey) of the x and y directions. The $E_x$ and the Ey can be determined from energies obtained in a single quantum well in the absence of an electric field.

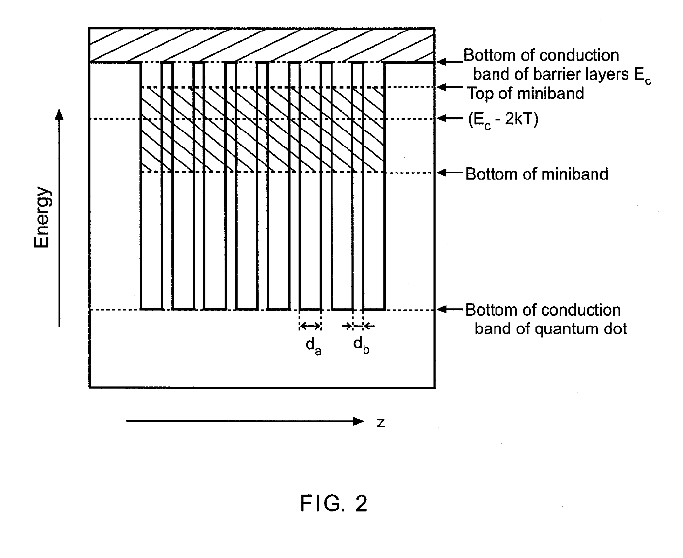

Fig. 2 is a schematic band diagram illustrating an energy level of a conduction band of the superlattice semiconductor layer 10 taken along a chain line in Fig. 1. The miniband can be formed as illustrated in Fig. 2 by controlling the size $d_a$ of each of the quantum dots 7 in the thickness direction, a space $d_b$ between two adjacent quantum dots in the thickness direction, the material of the quantum dots 7, and the material of the barrier layers 8.

The energy level at a bottom of the miniband formed in the superlattice semiconductor layer 10 is lower than the energy level at the bottom of the conduction band of the barrier layer 8. The energy difference between the top of a valence band of the barrier layers 8 or the quantum dots 7 and the bottom of the miniband is smaller than the energy difference between the top of the valence band of the barrier layers 8 or the quantum dots 7 and the bottom of the conduction band of the barrier layers 8, whereby electrons in the valence band can be photoexcited to the miniband with light having longer wavelength.

The energy level at the top of the miniband formed in the superlattice semiconductor layer 10 is higher than an energy level ($E_c$ - 2kT) ($E_c$ - 52 meV, which is lower than the energy level $E_c$ at the bottom of the conduction band of the barrier layers 8 by an amount twice as much as thermal energy kT (k: Boltzmann constant, T: absolute temperature) at room temperature. With this configuration, the probability of the electrons in the miniband being thermally excited to the conduction band of the barrier layers 8 can be made as 10% or more according to Fermi distribution function at room temperature, whereby carriers generated in the superlattice semiconductor layer 10 can efficiently be extracted.

The energy level at the top of the miniband formed in the superlattice semiconductor layer 10 may be higher than the energy level at the bottom of the conduction band of the barrier layers 8. With this configuration, the electrons in the miniband can more easily move to the conduction band of the barrier layers 8.

A solar cell having a conventional superlattice structure has poor extraction efficiency of carriers generated in the quantum layer. Carriers in the quantum level or in the miniband have to be excited up to the energy level at the bottom of the conduction band of the barrier layers. However, the probability of the photoexcitation is low, and during the thermal excitation, the energy barrier is so larger than the thermal energy for the carriers generated in the quantum layers as to discourage carrier excitation.

The miniband formed in the superlattice semiconductor layer 10 by quantum levels of the quantum dots 7 at the side of the conduction band may only be one as illustrated in Fig. 2. With this configuration, the generated carriers can efficiently be extracted from the p-n electrode in the absence of relaxation between minibands.

When plural minibands are formed by the quantum levels of the quantum dots at the conduction-band side, carriers generated in the second or the subsequent miniband with higher energy might move to the first miniband (ground-state energy) in a short period, so that a ratio of carriers, which cannot escape from the quantum dot layers but recouple and disappear, is high.

Methods of forming the superlattice semiconductor layer 10 having therein the miniband illustrated in Fig. 2 include a method of adjusting the quantum dot size $d_a$ of the quantum dot layers 6 and the thickness $d_b$ of each of the barrier layers 8. Another method is the one of varying the material of the quantum dots in the quantum dot layers or the material of the barrier layers. If $In_xGa_{1-x}As$ ($0 \leq x \leq 1$) is used, the mixed crystal ratio x is varied, whereby the bandgap, the effective mass of the carriers, and the barrier height of the valence band and the conduction band can be changed. Accordingly, the position and the width of the miniband can be adjusted with this method.

The above-described structure is also applicable to a quantum well solar cell including quantum well layers allowing miniband formation. However, quantum dots by three-dimensional confinement are more preferable, in which energy level of the miniband is easy to be high, compared with quantum wells by only one-dimensional confinement.

A solar cell having the configuration same as that in the present embodiment can be combined to a light-concentrating system. In this case, the solar cell 20 comprises: a p-type semiconductor layer 1; an n-type semiconductor layer 12; and a superlattice semiconductor layer 10 interposed between the p-type semiconductor layer 1 and the n-type semiconductor layer 12, wherein the superlattice semiconductor layer 10 has a stacked structure in which quantum layers 6 and barrier layers 8 are stacked alternately and repeatedly, and the superlattice semiconductor layer 10 is formed so that a miniband is formed by a quantum level of the quantum layer 6 on a side of a conduction band, wherein an energy level at a bottom of the miniband is lower than an energy level at a bottom of the conduction band of the barrier layers 8, and an energy level at a top of the miniband is higher than an energy level, which is lower than the energy level at the bottom of the conduction band of the barrier layers 8 by an amount twice as much as thermal energy kT (k: Boltzmann constant, T: absolute temperature) at a temperature of concentrating light.

With this configuration, the probability of the electrons in the miniband being thermally excited to the conduction band of the barrier layers 8 can be made as 10% or more according to Fermi distribution function at the temperature of concentrating light, whereby carriers generated in the superlattice semiconductor layer 10 can efficiently be extracted, and hence, short-circuit current can drastically be increased.

3. Method for producing solar cell

The superlattice semiconductor layer 10 can be formed by molecular beam epitaxy (MBE) or metal-organic chemical vapor deposition (MOCVD). Generally, quantum dots can be grown by a mode called Stranski-Krastanov (S-K) growth. In this mode, the mixed crystal ratio of the quantum dot 7 or a quantum well can be adjusted by varying the constituent ratio of materials, and the size of the quantum dot 7 or the width of a quantum well can be adjusted by varying the materials, growth temperature, pressure and/or deposition time.

As the solar cell 20 of the present embodiment, a quantum dot solar cell can be produced by molecular beam epitaxy (MBE), which is better at film thickness control, or metal-organic chemical vapor deposition (MOCVD), for example. The solar cell 20 of the present embodiment can be produced with GaAs as a material of the matrix semiconductors (the material of the barrier layers 8) and indium gallium arsenide ($In_xGa_{1-x}As$) whose bandgap can be easily varied in a range of approximately 1.43 eV (GaAs) to 0.36 eV (indium arsenide: InAs) according to the mixed crystal ratio x as a material of the quantum dots 7, for example. Hereinafter, the method for producing the solar cell 20 will be described in detail.

First, a p-GaAs substrate serving as the p-type semiconductor substrate 1 is washed with an organic cleaning solvent, etched with a sulfuric acid based etching solution, further washed with running water for 10 minutes, and then set in an MOCVD apparatus. On the p-type semiconductor substrate 1, a $p^+$-GaAs layer having a thickness of 300 nm is formed as the buffer layer 3. The buffer layer 3 is to improve the crystallinity of a light absorption layer to be formed thereon. Subsequently, on the $p^+$-GaAs buffer layer 3, a p-GaAs layer having a thickness of 300 nm and a GaAs layer having a thickness of 1 nm are formed by crystal growth as the base layer 4 and the barrier layer 8, respectively, and then an InAs (x = 1) layer is formed as the quantum dot layer 6 by self-organized growth. A unit of the crystals grown as the barrier layer 8 and the quantum dot layer 6 can be repeated, whereby the quantum dot layers 6 are stacked.

After the crystal growth of the quantum dot layers 6, a GaAs cap layer (not shown) having a thickness of approximately 4 nm is grown to regain the flatness of a surface of the crystal to complete the superlattice semiconductor layer 10. Subsequently, on the cap layer, an n-GaAs layer having a thickness of 250 nm is formed as the n-type semiconductor layer 12 by crystal growth to form a p-i-n structure, and then an $n-Al_{0.75}Ga_{0.25}As$ layer having a thickness of 50 nm is formed as the window layer 14. Then, a $p^+$-GaAs layer having a thickness of 100 nm is formed as the contact layer 15 by crystal growth. Next, the layers stacked are taken out of the MOCVD apparatus, and then the p-type electrode 18 is formed on the entire bottom surface of the substrate. Then, on the contact layer 15, an interdigitated electrode is formed by photo-lithography and lift-off process, and then the contact layer 15 is selectively etched with the interdigitated electrode as a mask to form the n-type electrode 17. Thus, the quantum dot solar cell 20 can be formed.

The temperature for processing the substrate may be 520°C only for the formation of the superlattice semiconductor layer 10 including the quantum dot layers 6 in order to prevent re-desorption of In and may be 590°C for the crystal growth of the other layers, for example.

Si may be used as an n-type dopant and Be may be used as a p-type dopant, for example. The electrode may be formed of Au by vacuum deposition by resistance heat deposition, for example.

The embodiment described herein is merely an example, and the constituents such as the substrate, the buffer layer, the quantum dots, the dopants and the electrodes to use for the solar cell of the present invention; and the cleaning agent, the temperature for processing the substrate, the apparatus to employ in each production process are not limited to those mentioned in the example.

Simulation experiments involved with solar cell according to first embodiment

Simulation experiments in which the Kronig-Penny model that was one-dimensional model was solved (including the simulation in which the Schroedinger equation was solved) by using MATLAB software were carried out.

The dispersion relation (E-k dispersion) of the conduction band and the valence band can be calculated by solving the Kronig-Penny model, whereby the position and width of the miniband can be obtained (e.g., see JOURNAL OF APPLIED PHYSICS, vol. 89, page 5509, 2001). Parameters contributing to the position and width of the miniband include a quantum dot size or a thickness of a quantum well, a thickness of barrier layers, effective mass of the material of the quantum layers or the material of the barrier layers in the conduction band or in the valence band (heavy hole, light hole), and the barrier height of the conduction band or the valence band. The position and width of the miniband can be obtained by substituting these values into the above-mentioned Kronig-Penny model.

[Experiment 1]

In Experiment 1, there was carried out a simulation for calculating the dispersion relation in the superlattice structure in which gallium arsenide (GaAs) was used for matrix semiconductor materials for forming barrier layers, an n-type semiconductor layer and a p-type semiconductor layer, and indium gallium arsenide ($In_{0.2}Ga_{0.8}As$) was used for a material of quantum dots for forming quantum dot layers.

Each of the quantum dots was rectangular solid, and the size (height) in the stacking direction was 6 nm, while the size in in-plane direction was 10 nm. The thickness of each of the barrier layers was 1 nm. The effective mass of electrons in gallium arsenide (GaAs) was $0.067m_0$, while the effective mass of electrons in indium gallium arsenide $(In_{0.2}Ga_{0.8}As)$ was $0.058m_0$. The effective mass of heavy holes in gallium arsenide (GaAs) was $0.349m_0$, while the effective mass of heavy holes in indium gallium arsenide $(In_{0.2}Ga_{0.8}As)$ was $0.346m_0$. The effective mass of light holes in gallium arsenide (GaAs) was $0.090m_0$, while the effective mass of light holes in indium gallium arsenide $(In_{0.2}Ga_{0.8}As)$ was $0.077m_0$. The barrier height of the conduction band between the gallium arsenide and the indium gallium arsenide was 0.189 eV, while the barrier height of the valence band was 0.101 eV. Here, mo is a mass of electrons, which is 9.11 x $10^{-31}$ kg.

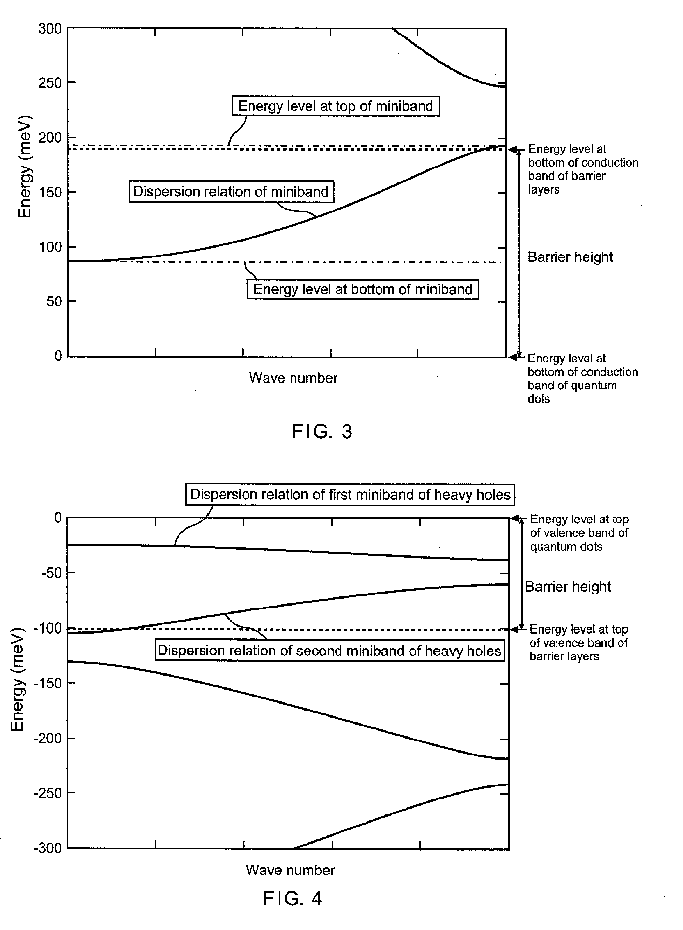

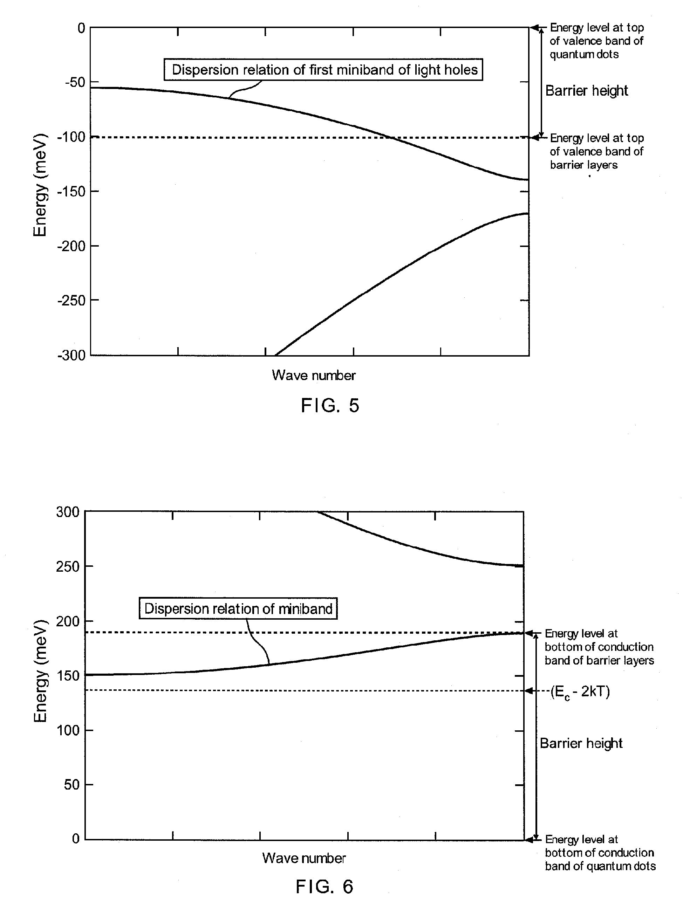

Fig. 3 illustrates the dispersion relation, calculated in the Experiment 1, in the conduction band in the superlattice structure, Fig. 4 illustrates the dispersion relation in the valence band (heavy hole), and Fig. 5 illustrates the dispersion relation in the valence band (light hole). In these graphs, an abscissa axis represents a wave number, and an ordinate axis represents energy. The energy value is illustrated such that the energy level at the bottom of the conduction band or at the top of the valence band in the bulk of the material constituting the quantum dot is defined as zero. The energy level at the bottom of the conduction band of the barrier layers or at the top of the valence band of the barrier layers is indicated by a dotted line.

It is found that, under such a condition, only one miniband is formed in the conduction band, wherein the energy at the bottom of the miniband is lower than the energy level at the bottom of the conduction band of the barrier layers, and the energy at the top of the miniband in the conduction band is higher than the energy level at the bottom of the conduction band of the barrier layers. This will be described below in more detail with reference to Figs. 3 to 5.

It is understood from Fig. 3 that only one miniband is formed in the conduction band, wherein the energy (0.087 eV) at the bottom of the miniband is lower than the energy level (0.189 eV) at the bottom of the conduction band of the barrier layers, and the energy (0.193 eV) at the top of the miniband is higher than the energy level (0.189 eV) at the bottom of the conduction band of the barrier layers. This shows that the generated electrons are thermally excited in the miniband, and can easily be extracted from the n-type semiconductor layer.

Figs. 4 and 5 show that plural minibands (first miniband of heavy holes: -0.025 - -0.037 eV, second miniband of heavy holes: - 0.060 ~ -0.101 eV that is the barrier height of the valence band, or less, first miniband of light holes: -0.056 ~ -0.101 eV that is the barrier height of the valence band, or less) are formed in the valence band, wherein the minibands are almost continuously formed at energy levels smaller than the energy at the top of the miniband with the highest energy level in the valence band, and the generated holes are easily extracted from the p-type semiconductor layer by phonon scattering.

From the above, the quantum dot structure according to Experiment 1 can efficiently extract carriers, which are generated not only by a light transition corresponding to the bandgap of the matrix semiconductor material but also by optical energy less than the bandgap of the matrix semiconductor material utilizing the miniband, whereby the short-circuit current increases.

[Experiment 2]

In Experiment 2, there was carried out a simulation for calculating the dispersion relation of the superlattice structure in which gallium arsenide (GaAs) was used for matrix semiconductor materials for forming barrier layers, an n-type semiconductor layer and a p-type semiconductor layer, and indium gallium arsenide $(In_{0.2}Ga_{0.8}As)$ was used for a material of quantum dots for forming quantum dot layers. Experiment 2 is an example of a quantum dot solar cell in which the position and width of the miniband are adjusted by varying the size of each quantum dot of the quantum dot layers and the thickness of each barrier layer in Experiment 1.

Each of the quantum dots was rectangular solid, and the size (height) in the stacking direction was 8 nm, while the size in in-plane direction was 6 nm. The thickness of each of the barrier layers was 2 nm. The effective mass of electrons in gallium arsenide (GaAs) was $0.067m_0$, while the effective mass of electrons in indium gallium arsenide $(In_{0.2}Ga_{0.8}As)$ was $0.058m_0$. The barrier height of the conduction band between the gallium arsenide and the indium gallium arsenide was 0.189 eV. Here, $m_0$ is a mass of electrons, which is 9.11 x 10-31 kg.

Fig. 6 illustrates the dispersion relation, calculated in Experiment 2, in the conduction band in the superlattice structure. In Fig. 6, an abscissa axis represents a wave number, and an ordinate axis represents energy. The energy value is illustrated such that the the energy level at the bottom of the conduction band in the bulk of the material constituting the quantum dot is defined as zero. The energy level at $E_c$ at the bottom of the conduction band of the barrier layer and the energy level at $(E_c - 2kT)$ are indicated by a dotted line. Fig. 6 corresponds to Fig. 3 in Experiment 1.

It is found that, under such a condition, only one miniband is formed in the conduction band, wherein the energy at the bottom of the miniband is lower than the energy of the barrier layers, and the energy at the top of the miniband in the conduction band is higher than an energy level, which is lower than the energy level at the bottom of the conduction band of the barrier layers by an amount twice as much as thermal energy kT (k: Boltzmann constant, T: absolute temperature) at room temperature. This will be described below in more detail with reference to Fig. 6.

It is understood from Fig. 6 that only one miniband is formed in the conduction band, wherein the energy (0.150 eV) at the bottom of the miniband is lower than the energy level (0.189 eV) at the bottom of the conduction band of the barrier layers, and the energy (0.188 eV) at the top of the miniband is higher than the energy level (0.137 eV) that is lower than the energy level at the bottom of the conduction band of the barrier layers by an amount twice as much as the thermal energy kT (k: Boltzmann constant, T: absolute temperature) at room temperature. This shows that the generated electrons are thermally excited in the miniband, and can easily be extracted from the n-type semiconductor layer. In the valence band, plural minibands are formed, and the generated holes are easily extracted from the p-type semiconductor layer by the phonon scattering, as in Experiment 1.

The quantum dot structure according to Experiment 2 can efficiently extract carriers, which are generated not only by a light transition corresponding to the bandgap of the matrix semiconductor material but also by optical energy less than the bandgap of the matrix semiconductor material utilizing the miniband, whereby the short-circuit current increases.

It is understood from the above that the position and width of the miniband can be adjusted by varying the size of each quantum dot in the quantum dot layers, and the thickness of each barrier layer, whereby a superlattice structure that can be adapted to solar spectrum can be formed.

[Experiment 3]

In Experiment 3, there was carried out a simulation for calculating the dispersion relation of the superlattice structure in which gallium arsenide (GaAs) was used for matrix semiconductor materials for forming barrier layers, an n-type semiconductor layer and a p-type semiconductor layer, and indium gallium arsenide ($In_{0.5}Ga_{0.8}As$) was used for a material of quantum dots for forming quantum dot layers. Experiment 3 is an example of a quantum dot solar cell in which the position and width of the miniband are adjusted for the material of the quantum dots different from those in Experiments 1 and 2.

Each of the quantum dots was rectangular solid, and the size (height) in the stacking direction was 6 nm, while the size in in-plane direction was 4 nm. The thickness of each of the barrier layers was 1 nm. The effective mass of electrons in gallium arsenide (GaAs) was $0.067m_0$, while the effective mass of electrons in indium gallium arsenide ($In_{0.5}Ga_{0.8}As$) was $0.045m_0$. The barrier height of the conduction band between the gallium arsenide and the indium gallium arsenide was 0.426 eV. Here, mo is a mass of electrons, which is 9.11 x 10-31 kg.

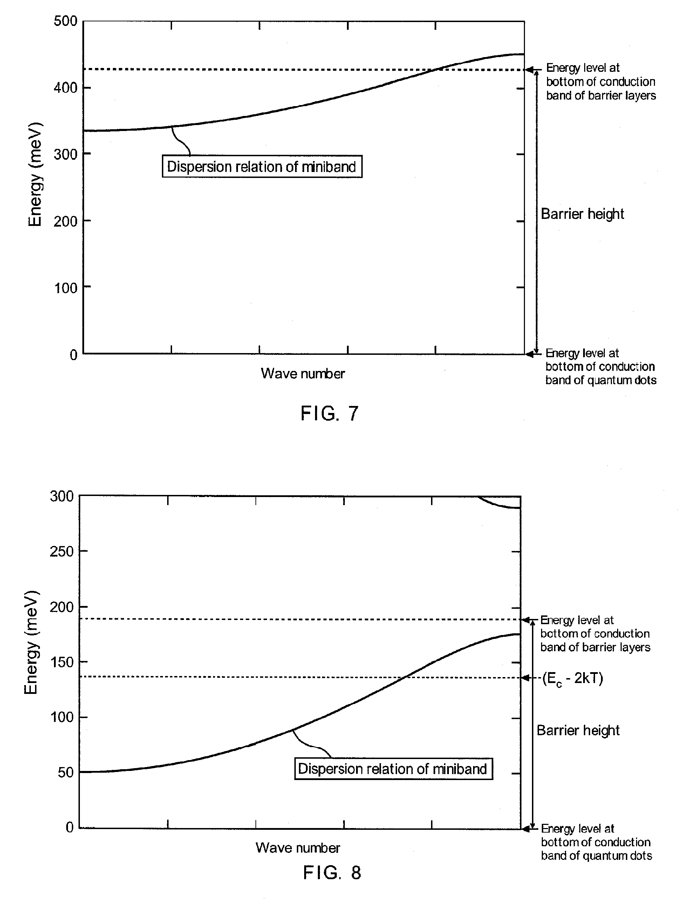

Fig. 7 illustrates the dispersion relation, calculated in Experiment 3, in the conduction band in the superlattice structure. In Fig. 7, an abscissa axis represents a wave number, and an ordinate axis represents energy. The energy value is illustrated such that the energy level at the bottom of the conduction band in the bulk of the material constituting the quantum dot is defined as zero. The energy level at the bottom of the conduction band of the barrier layers is indicated by a dotted line. Fig. 7 corresponds to Fig. 3 in Experiment 1.

It is found that, under such a condition, only one miniband is formed in the conduction band, wherein the energy at the bottom of the miniband is lower than the energy level at the bottom of the conduction band of the barrier layers, and the energy at the top of the miniband is higher than the energy level at the bottom of the conduction band of the barrier layers. This will be described below in more detail with reference to Fig. 7.

It is understood from Fig. 7 that only one miniband is formed in the conduction band, wherein the energy (0.335 eV) at the bottom of the miniband is lower than the energy level (0.426 eV) at the bottom of the conduction band of the barrier layers, and the energy (0.451 eV) at the top of the miniband is higher than the energy level (0.426 eV) at the bottom of the conduction band of the barrier layers. This shows that the generated electrons are thermally excited in the miniband, and can easily be extracted from the n-type semiconductor layer. In the valence band, plural minibands are formed, and the generated holes are easily extracted from the p-type semiconductor layer by the phonon scattering, as in Experiment 1 and in Experiment 2.

The quantum dot structure according to Experiment 3 can efficiently extract carriers, which are generated not only by a light transition corresponding to the bandgap of the matrix semiconductor material but also by optical energy less than the bandgap of the matrix semiconductor material utilizing the miniband, whereby the short-circuit current increases.

It is understood from the above that the position and width of the miniband can also be adjusted even in the quantum dot structure using different material for the quantum dots.

[Experiment 4]

In Experiment 4, there was carried out a simulation for calculating the dispersion relation of the superlattice structure in which gallium arsenide (GaAs) was used for matrix semiconductor materials for forming barrier layers, an n-type semiconductor layer and a p-type semiconductor layer, and indium gallium arsenide ($In_{0.2}Ga_{0.8}As$) was used for a material of quantum wells for forming quantum well layers. Experiment 4 is an example of a quantum well solar cell in which quantum well is employed for forming the quantum layers in the superlattice structure, and the position and width of the miniband are adjusted by varying the width of the quantum well.

The thickness of each of the quantum well layers was 4 nm. The effective mass of electrons in gallium arsenide (GaAs) was $0.067m_0$, while the effective mass of electrons in indium gallium arsenide ($In_{0.2}Ga_{0.8}As$) was $0.058m_0$. The barrier height of the conduction band between the gallium arsenide and the indium gallium arsenide was 0.189 eV. Here, $m_0$ is a mass of electrons, which is $9.11 \times 10^{-31}$ kg.

Fig. 8 illustrates the dispersion relation, calculated in Experiment 4, in the conduction band in the superlattice structure. In Fig. 8, an abscissa axis represents a wave number, and an ordinate axis represents energy. The energy value is illustrated such that the energy level at the bottom of the conduction band in the bulk of the material constituting the quantum well is defined as zero. The energy level at the bottom of the conduction band of the barrier layers and the energy level at ($E_c$ - 2kT) are indicated by a dotted line. Fig. 8 corresponds to Fig. 3 in Experiment 1.

It is found that, under such a condition, only one miniband is formed in the conduction band, wherein the energy at the bottom of the miniband is lower than the energy of the barrier layers, and the energy at the top of the miniband in the conduction band is higher than an energy level ($E_c$ - 2kT), which is lower than the energy level at the bottom of the conduction band of the barrier layers by an amount twice as much as thermal energy kT (k: Boltzmann constant, T: absolute temperature) (26 meV) at room temperature. This will be described below in more detail with reference to Fig. 8.

It is understood from Fig. 8 that only one miniband is formed in the conduction band, wherein the energy (0.050 eV) at the bottom of the miniband is lower than the energy level (0.189 eV) at the bottom of the conduction band of the barrier layers, and the energy (0.176 eV) at the top of the miniband is higher than the energy level (0.137 eV) that is lower than the energy level at the bottom of the conduction band of the barrier layers by an amount twice as much as thermal energy kT (k: Boltzmann constant, T: absolute temperature) (26 meV) at room temperature. This shows that the generated electrons are thermally excited in the miniband, and can easily be extracted from the n-type semiconductor layer. In the valence band, plural minibands are formed, and the generated holes are easily extracted from the p-type semiconductor layer by the phonon scattering, as in Experiment 1 and in Experiment 2.

The quantum well structure according to Experiment 4 can efficiently extract carriers, which are generated not only by a light transition corresponding to the bandgap of the matrix semiconductor material but also by optical energy less than the bandgap of the matrix semiconductor material utilizing the miniband, whereby the short-circuit current increases.

It is understood from the above that the position and width of the miniband can also be adjusted even in the quantum well structure including quantum well layers as quantum layers in the superlattice structure.

Configuration of solar cell according to second embodiment

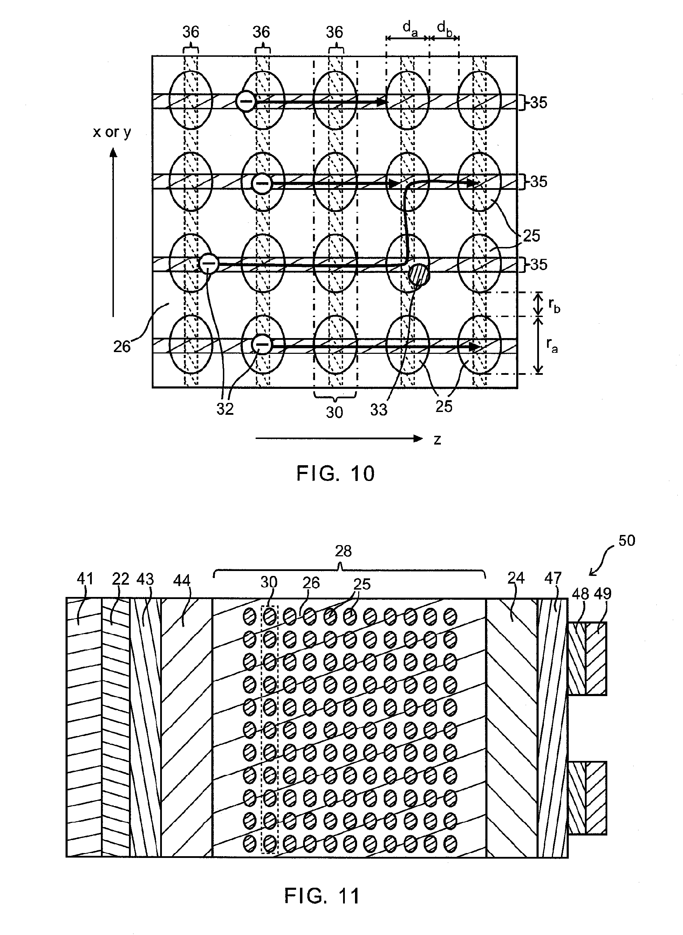

Fig. 11 is a schematic cross-sectional view illustrating a configuration of a solar cell according to an embodiment of the present invention.

A solar cell 50 of the present embodiment comprises: a p-type semiconductor layer 22; an n-type semiconductor layer 24; and a superlattice semiconductor layer 28 interposed between the p-type semiconductor layer 22 and the n-type semiconductor layer 24, wherein the superlattice semiconductor layer 28 has a stacked structure in which barrier layers 26 and quantum dot layers 30, each quantum dot layer comprising quantum dots 30 surrounded by a semiconductor material constituting the barrier layers 26, are stacked alternately and repeatedly, and the superlattice semiconductor layer 28 is formed so that an intermediate band is formed in both a thickness direction of the superlattice semiconductor layer 28 and in a direction (in in-plane direction of the quantum dot layers 30) orthogonal to the thickness direction of the superlattice semiconductor layer 28.

The solar cell 50 of the present embodiment may further have an anode 41, a buffer layer 43, a base layer 44, a window layer 47, a contact layer 48, and a cathode 49.

The buffer layer 43 serves as a buffer layer between the p-type semiconductor layer 22 and the superlattice semiconductor layer 28. The base layer 44 is formed to serve as a base of the superlattice semiconductor layer 28. The window layer 47 has a function of transmitting solar light, and the contact layer 48 is formed to enhance adhesion between a material of the cathode 49 and a material of the n-type semiconductor layer 24.

1. Anode and cathode

The solar cell 50 can include the anode 41 and the cathode 49. The anode 41 and the cathode 49 are provided to be capable of outputting a photovoltaic power of the solar cell 50.

Examples of materials used for the anode 41 and the cathode 49 include a metal material such as gold, silver, copper, titanium, or aluminum, or an alloy containing these metal materials; a conductive oxide material such as indium tin oxide (ITO) or indium zinc oxide (IZO); various semiconductor materials such as silicon, gallium arsenide, or a material formed by injecting dopants such as boron or phosphor to these materials at high concentration for enhancing conductivity; various conductive materials, e.g., a conductive organic material such as PEDOT:PSS or polythiophene; and a mixture or compound of these materials. When a substrate is used as a device constituent, the anode 41 and the cathode 49 may have a multilayer structure such as a double-layer structure including a material having satisfactory adhesion to the substrate and an anode material or a cathode material in order to enhance adhesion to the substrate.

The anode 41 and the cathode 49 can be formed by a physical vapor deposition such as a resistance heating process, an electron beam evaporation, or a sputtering process for forming a target electrode material on the substrate. The anode 41 and the cathode 49 can be formed as a high conductive material prepared by doping dopants into a semiconductor material at high concentration with an ion implantation. The anode 41 and the cathode 49 can also be formed by a patterning using a photolithography.

The substrate and the anode 41, or the substrate and the cathode 49 may integrally be formed from the same material. For example, a low resistance silicon substrate having doped therein impurities at high concentration is used as the substrate, and this silicon substrate may be utilized as the anode 41 or the cathode 49.

2. p-type semiconductor layer and n-type semiconductor layer

The p-type semiconductor layer 22 is formed of a semiconductor including p-type impurities and can form a p-i-n junction or a p-n junction with the superlattice semiconductor layer 28 and the n-type semiconductor layer 24.

The n-type semiconductor layer 24 is formed of a semiconductor including n-type impurities and can form a p-i-n junction or a p-n junction with the superlattice semiconductor layer 28 and the p-type semiconductor layer 22.

The p-i-n junction or the p-n junction develops an electromotive force when subjected to light. With this process, the solar cell can output power.

The p-type semiconductor layer 22 or the n-type semiconductor layer 28 are not particularly limited, so long as they can separate electrons and holes generated by light received by the superlattice semiconductor layer 28 and output these as photovoltaic power.

3. Superlattice semiconductor layer

The superlattice semiconductor layer 28 is interposed between the p-type semiconductor layer 22 and the n-type semiconductor layer 24, and can form a p-i-n junction or a p-n junction. The superlattice semiconductor layer 28 has a superlattice structure in which barrier layers 26 and quantum dot layers 30, each of which includes quantum dots 25 surrounded by a semiconductor material constituting the barrier layers 26, are stacked alternately and repeatedly. The superlattice semiconductor layer 28 may be an i-type semiconductor layer or a semiconductor layer including p-type impurities or n-type impurities as long as development of an electromotive force is caused by light received.

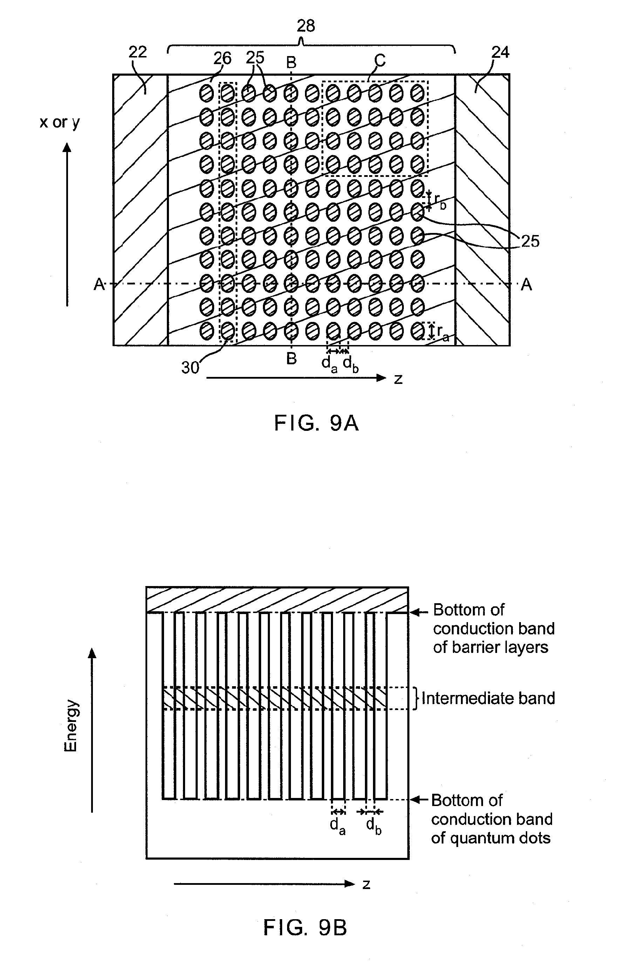

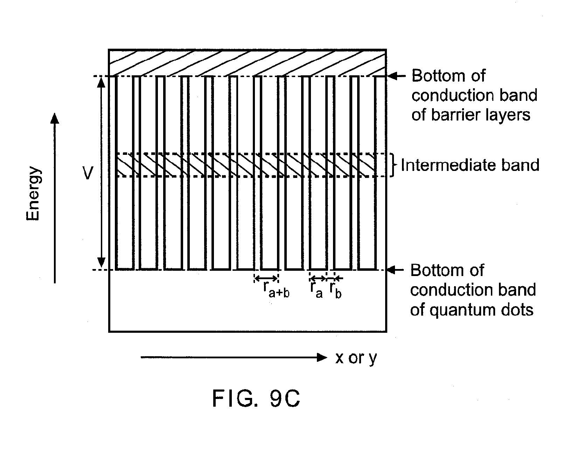

Fig. 9A is a schematic cross-sectional view of the superlattice semiconductor layer and other layers included in the solar cell according to one embodiment of the present invention, Fig. 9B is a schematic bandgap diagram illustrating an energy level in a conduction band of the superlattice semiconductor layer taken along a chain line A - A in Fig. 9A, and Fig. 9C is a schematic bandgap diagram illustrating an energy level in a conduction band of the superlattice semiconductor layer taken along a chain line B - B in Fig. 9A. In Figs. 9A, 9B, and 9C, an internal electric field generated by the p-i-n junction is neglected. Figs. 9A, 9B, and 9C illustrate only the level for forming the intermediate band out of quantum levels of the quantum dots 25, wherein the band where electrons can be present is indicated by a hatched line.

Fig. 10 is an enlarged cross-sectional view of a region C, enclosed by a dotted line in Fig. 9A, in the superlattice semiconductor layer. Fig. 10 is an explanatory view for describing electrons moving in the intermediate band.

As illustrated in Figs. 9A, 9B, and 9C, the quantum dots 25 included in the solar cell are microparticles made of a material having a bandgap narrower than that of the material for the barrier layers 26. The conduction band of the quantum dots 25 is confined by the barrier layers 26, thereby forming a quantum level.

The superlattice semiconductor layer 28 has a stacked structure in which the intermediate band is formed in both the thickness direction (z direction in Fig. 9) of the superlattice semiconductor layer 28 and in the in-plane direction (the direction orthogonal to the thickness direction of the superlattice semiconductor layer 28) (x direction or y direction in Fig. 9) of the quantum dot layers 30. The superlattice semiconductor layer 108 included in the conventional intermediate-band solar cell has the intermediate band only in the thickness direction (z direction in Fig. 23) of the superlattice semiconductor layer 108. This will be described below with reference to the drawings.

In the conventional intermediate-band solar cell, the intermediate band is formed in the z direction as illustrated in Fig. 23B. However, the diameter $s_a$ of each of the quantum dots 105 and the space $S_b$ between two adjacent quantum dots 105 in the in-plane direction (x direction or y direction) of the quantum dot layers 110 are not controlled. Therefore, the wave functions at the quantum levels of two quantum dots, adjacent to each other in the x direction or in the y direction, hardly interact, resulting in that the intermediate band is not formed in the x direction or in the y direction as illustrated in Fig. 23C. Therefore, electrons 112 excited from the valence band to the intermediate band move in the intermediate band 115 formed in the thickness direction (z direction) of the superlattice semiconductor layer 108 as illustrated in Fig. 24. Accordingly, a degree of freedom of carriers (electrons 112) is limited only in the stacking direction (z direction) of the quantum dot layers 110. On the other hand, during a process of forming a superlattice structure, a carrier trap 113 such as a defect is caused inside of the quantum dot 105. Specifically, the carrier trap 113 such as a defect is liable to be caused in the intermediate band 115 serving as a carrier path.

When the carrier trap 103 is present in the intermediate band 115 in the intermediate-band solar cell including the quantum dots 105 as in the conventional technique, the degree of freedom of the carriers (electrons 112) is limited only in the stacking direction (z direction) of the quantum dot layers 110. Therefore, the carriers are easily trapped. It is considered that, since the trapped carriers are deactivated without contributing to the photovoltaic power, the short-circuit current density might be reduced.

Accordingly, the conventional intermediate-band solar cell including the quantum dots has a structure in which the carriers are difficult to be extracted as current, since they are liable to be deactivated. Therefore, the current value externally extracted is considered to be low.

On the other hand, the superlattice semiconductor layer 28 included in the solar cell 50 according to the present embodiment illustrated in Fig. 9 has a stacking structure through the control of not only a diameter $d_a$ of each quantum dot 25 and a space $d_b$ between two adjacent quantum dots 25 in the thickness direction (z direction) of the superlattice semiconductor layer 28, but also a diameter $r_a$ of each quantum dot 25 and a space $r_b$ between two adjacent quantum dots 25 in the in-plane direction (x direction or y direction) of the quantum dot layers 30. Therefore, the intermediate band is formed in both the thickness direction (z direction) of the superlattice semiconductor layer 28 and the in-plane direction (x direction or y direction) of the quantum dot layers 30.

The wave functions at the quantum levels of two quantum dots 25, adjacent to each other in the z direction, interact with each other by controlling $d_a$ and $d_b$, whereby the intermediate band can be formed in the z direction of the superlattice semiconductor layer 28 as illustrated in Fig. 9B. Specifically, in the stacking direction (z direction) of the quantum dot layers, the intermediate band that passes through the quantum dots 25 in the stacking direction of the quantum dot layers and that is continuous over the stacking direction of the quantum dot layers can be formed.

The intermediate band is formed in such a manner that the wave functions extend over the stacking direction without being localized on each of the quantum dots 25 in the stacking direction. Specifically, the intermediate band is formed in such a manner that the quantum dots 25 greatly interact with the adjacent quantum dots 25 to prevent the localization of the wave functions.

The width of the intermediate band is set to be the width not less than the energy corresponding to the temperature held by the solar cell. For example, if the width of the intermediate band is 26 meV or more at room temperature, it can be regarded that the band is formed.

The carriers generated in the quantum dot layers 30 move in the intermediate band, which is formed such that the wave functions are continuous over the superlattice semiconductor layer from the p-type semiconductor layer to the n-type semiconductor layer of the superlattice semiconductor layer 28, and can easily move to the n-type semiconductor layer.

The wave functions at the quantum levels of two quantum dots 25, adjacent to each other in the x direction or in the y direction, interact with each other by controlling $r_a$ and $r_b$, whereby the intermediate band can be formed in the x direction or in the y direction of the superlattice semiconductor layer 28 as illustrated in Fig. 9C. Specifically, the intermediate band that passes through the quantum dots 25 in the in-plane direction of the quantum dot layers and that is continuous over the in-plane direction of the quantum dot layers can be formed even in the in-plane direction (x direction or y direction) of the quantum dot layers.

The intermediate band in the in-plane direction of the quantum dot layers can equally be considered to the intermediate band in the stacking direction of the quantum dot layers.

Specifically, in the in-plane direction of the quantum dot layers, the intermediate band that passes through the quantum dots 25 in the in-plane direction of the quantum dot layers and that is continuous over the in-plane direction of the quantum dot layers can be formed.

The intermediate band is formed in such a manner that the wave functions extend over the in-plane direction without being localized on each of the quantum dots 25 in the in-plane direction. Specifically, the intermediate band is formed in such a manner that the quantum dots 25 greatly interact with the adjacent quantum dots 25 to prevent the localization of the wave functions.

When the intermediate band is formed even in the in-plane direction of the quantum dot layers, the carrier transfer path can be formed in the stacking direction and in the in-plane direction of the quantum dot layers 30 as illustrated in Fig. 10. The carriers move in the stacking direction of the quantum dot layers due to the internal electric field, after being generated. In this case, the carriers can also move in the in-plane direction of the quantum dot layers due to the phonon scattering. The carriers, which are originally trapped by the carrier trap such as a defect to be deactivated in the conventional solar cell, can move without being trapped due to the movement in the in-plane direction.

Therefore, the carriers described above can be extracted as current without being deactivated. Consequently, the carriers can efficiently be extracted as current.

Some of the carriers present on the second or higher quantum level of the quantum dots 25 have energy reduced to the first quantum level due to relaxation. Therefore, if the intermediate band in the in-plane direction is formed for the first quantum level, the carriers whose energy is reduced to the first quantum level from the second or higher quantum level can efficiently be extracted as current.

The intermediate band in the in-plane direction of the quantum dot layers will be described below in more detail.

When the space between the quantum dots in the in-plane direction of the quantum dot layers 30 becomes not more than a certain distance, an electronic coupling is caused between the quantum dots. The directions other than the considered directions in the stacking direction and in-plane direction of the quantum dot layers can be considered by employing variable separation. Specifically, the wave function of the superlattice structure in the in-plane direction of the quantum dot layers can be regarded to be equal to the wave function of the one-dimensional quantum well structure for the axial direction of the in-plane direction of the quantum dot layers through the quantum dots 25.

The wave function of the one-dimensional quantum well structure can be simulated by using Kronig-Penny model employing a periodic boundary condition, and the width of the intermediate band can be calculated from this result (see, for example, JOURNAL OF APPLIED PHYSICS, vol. 89, page 5509, 1002). Examples of parameters contributing to the width of the intermediate band include a size of a quantum dot, a space between quantum dots, an effective mass of the material for the quantum dots and the material for the barrier layers, and a valence band and a conductive band of the material for the quantum dots and the material for the barrier layers. The condition of forming the intermediate band at a certain temperature can be obtained by substituting these values into the above-mentioned Kronig-Penny model.

The materials of the barrier layers 28 and the quantum dot layers 30 (quantum dots 25) constituting the superlattice semiconductor layer 28 are not particularly limited, and examples thereof include a group III-V compound semiconductor, a group II-VI compound semiconductor, and a mixed crystal of these materials. A chalcopyrite semiconductor may also be used. The quantum dot layers 30 are formed of a semiconductor material having a bandgap narrower than the barrier layers 26.

Examples of the combination of the materials of the barrier layers 26 and the quantum dots 25 include a combination of GaAs and $In_xGa_{1-x}As$, a combination of GaNAs and InAs, a combination of GaP and InAs, a combination of GaN and $Ga_xIn_{1-x}N$, a combination of GaAs and GaSb, a combination of AlAs and InAs, and a combination of $CuGaS_2$ and $CuInSe_2$. Here, x satisfies $0 < x \leq 1$.

When the combination of the materials for the barrier layers 26 and the quantum dots 25 is the one in which the material for the quantum dots is the mixed crystal including the material for the barrier layers in a ratio of x, such as the combination of GaAs and $In_xGa_{1-x}As$, x has to be not less than a certain value in order to form the significant superlattice structure. The reason is that, if x is small, the material compositions of the barrier layers and the quantum dots are almost the same, which provides no merit of forming the superlattice structure. In the combination of GaAs and $In_xGa_{1-x}As$ for the barrier layers and the quantum dots, x = 0.4 is established.

The superlattice structure included in the superlattice semiconductor layer 28 can be formed by molecular beam epitaxy (MBE) or metal-organic chemical vapor deposition (MOCVD). Generally, quantum dots can be grown by a mode called Stranski-Krastanov (S-K) growth. In this mode, the mixed crystal ratio of the quantum dot can be adjusted by varying the constituent ratio of materials, and the size of the quantum dot or can be adjusted by varying the materials, growth temperature, pressure and/or deposition time. The quantum dot layers 30 can be formed by a bionanoprocess using ferritin and neutral beam.

Method for manufacturing solar cell according to second embodiment

A method for manufacturing the solar cell 50 according to the present embodiment illustrated in Fig. 11 will specifically be described below.

First, a p-GaAs substrate serving as the p-type semiconductor layer 22 is washed with an organic cleaning solvent, etched with a sulfuric acid based etching solution, further washed with running water for 10 minutes, and then set in an MOCVD apparatus. On the p-GaAs substrate serving as the p-type semiconductor layer 22, a $p^+$-GaAs layer having a thickness of 300 nm is formed as the buffer layer 43. The buffer layer 43 is to improve the crystallinity of a light absorption layer to be formed thereon. Subsequently, on the $p^+$-GaAs buffer layer 43, a p-GaAs layer 44 having a thickness of 300 nm and a GaAs layer having a thickness of 1 nm are formed by crystal growth as the base layer 44 and the barrier layer 26, respectively, and then an InAs (x = 1) layer is formed as the quantum dot layer 30 including the quantum dots 25 by self-organized growth.

A unit of the crystals grown as the barrier layer 26 and the quantum dot layer 30 can be repeated from the quantum dots closest to the p-type semiconductor layer 22 toward the quantum dots closest to the n-type semiconductor layer 24.

After the crystal growth of the quantum dot layers 30, a GaAs cap layer (not shown) having a thickness of approximately 4 nm is grown to regain the flatness of a surface of the crystal to complete the superlattice semiconductor layer 28. Subsequently, on the cap layer, an n-GaAs layer having a thickness of 250 nm is formed as the n-type semiconductor layer 24 by crystal growth to form a p-i-n structure, and then an $n-Al_{0.75}Ga_{0.25}As$ layer having a thickness of 50 nm is formed as the window layer 47. Then, a $p^+$-GaAs layer having a thickness of 100 nm is formed as the contact layer 48 by crystal growth. Next, the layers stacked are taken out of the MOCVD apparatus, and then the anode 41 is formed on the entire bottom surface of the substrate. Then, on the contact layer 48, an interdigitated electrode is formed by photo-lithography and lift-off process, and then the contact layer 48 is selectively etched with the interdigitated electrode as a mask to form the cathode 49. Thus, the intermediate-band solar cell 50 having the quantum dots 25 can be formed.

The temperature for processing the substrate may be 520°C only for the formation of the superlattice semiconductor layer 28 including the quantum dot layers 30 in order to prevent re-desorption of In and may be 590°C for the crystal growth of the other layers, for example.

Si may be used as an n-type dopant and Be may be used as a p-type dopant, for example. The electrode may be formed of Au by vacuum deposition by resistance heat deposition, for example.

The embodiment described herein is merely an example, and the constituents such as the substrate, the buffer layer, the quantum dots, the dopants and the electrodes to use for the solar cell of the present invention; and the cleaning agent, the temperature for processing the substrate, the apparatus to employ in each production process are not limited to those mentioned in the example.

Simulation experiment 1 for solar cell according to second embodiment

Simulation experiments using simulation software MATLAB based upon Kronig-Penny model were carried out for checking the relationship between the diameter $r_a$ of each quantum dot and the space $r_b$ between two adjacent quantum dots for forming the intermediate band by the first quantum level of the quantum dot in the in-plane direction of the quantum dot layers.

As one example, the condition of forming the intermediate band in the conduction band was calculated, when the material for the barrier layers was GaAs, and the material for the quantum dots was $In_xGa_{1-x}As$.

In a general Kronig-Penny model, used parameters include the size $r_a$ of the quantum dot, the space $r_b$ between the quantum dots, the effective masses $m_a^*$ and $m_b^*$ of the materials for the quantum dots and for the barrier layers in the conduction band, and the difference V in the conduction band level between the material for the quantum dots and the material for the barrier layers.

In this example, the parameters are set such that $ma^* = 0.023m_0$, $m_b^* = 0.067m_0$, and V = 0.697 eV, when x = 1. The values of $m_b^*$ and V change according to the value of x. Here, mo is a mass of electrons, which is $9.11 \times 10^{-31}$ kg. The values of $m_b^*$ and V for each x can easily be calculated with reference to literatures. The relationship between $r_a$ and $r_b$ for forming the intermediate band in the in-plane direction of the quantum dot layers can be derived by substituting the parameters of $m_a^*$, $m_a^*$, and V into Kronig-Penny model, and calculating this model.

[Calculation example 1]

The condition for forming the band in the in-plane direction of the quantum dot layers was calculated, in the case of x = 0.4. The equation of x = 0.4 means the lower limit of the range of x ($0.4 \leq x \leq 1.0$) that is meaningful as the composition of forming the superlattice structure in the quantum dot layers using GaAs for the barrier layers and $In_xGa_{1-x}As$ for the quantum dots.

In the case of x = 0.4, the parameters were such that $ma^* = 0.0494m_0$, $m_b^* = 0.067m_0$, and V = 0.353 eV.

The relational expression for $r_a$ and $r_b$ in this case was derived as described below.

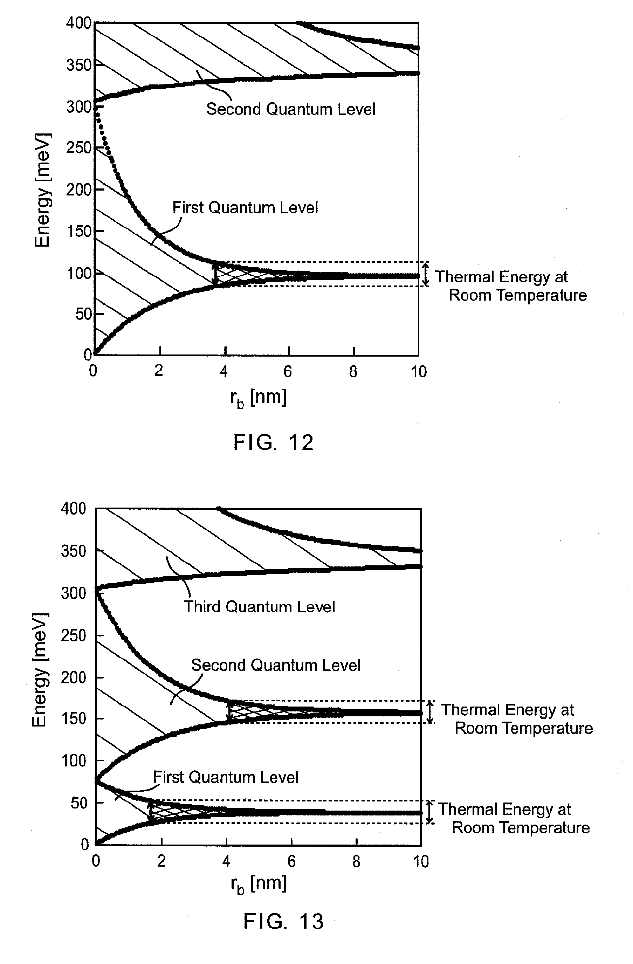

Firstly, the quantum level energy for $r_b$ in the conduction band in the case of $r_a$ = 5 nm was calculated. Fig. 12 illustrates the result.

A shaded area in Fig. 12 has a finite intermediate-band width, wherein the intermediate band is formed in a hatched stripe area. An energy width indicated by an arrow in the shaded area corresponds to the thermal energy at room temperature that is 26 meV. Therefore, if $r_b$ is smaller than the value pointing the arrow, the intermediate band is formed. It was found that, in the case of $r_a$ = 5 nm, the intermediate band of the first quantum level was formed if $r_b$ was smaller than 3.8 nm.

Similarly, the quantum level energy in the conduction band in case where $r_a$ was 10 nm, and $r_b$ was varied from 0 to 10 was calculated. Fig. 13 illustrates the result. In this case, it was found that the intermediate band of the first quantum level was formed if $r_b$ was smaller than 1.7 nm.

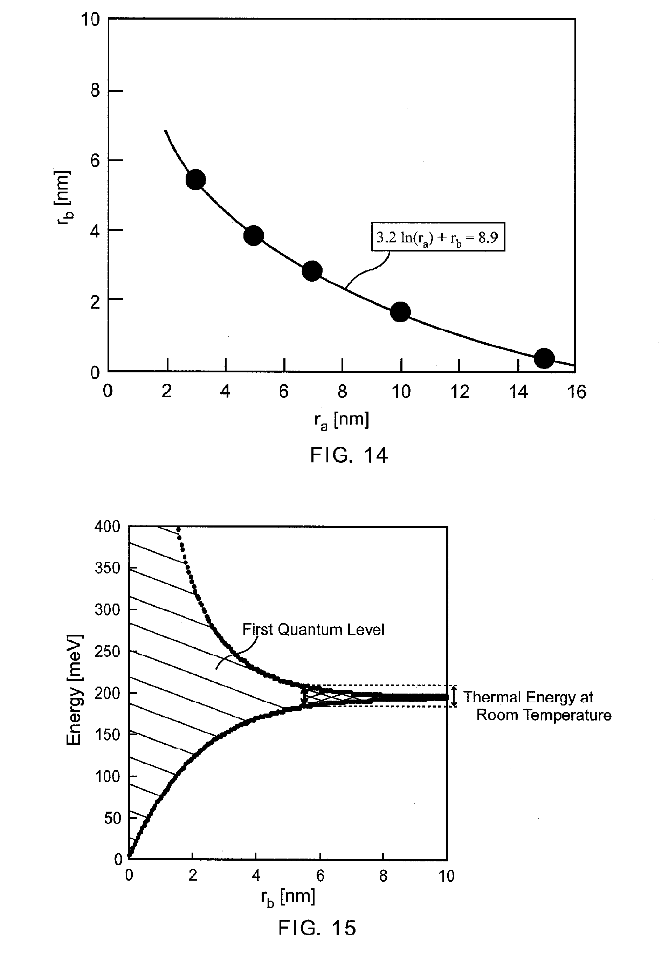

In this way, the similar calculation was executed to various values of $r_a$. Fig. 14 is a graph in which sets of $r_a$ and $r_b$ are plotted, each set being a threshold value for forming the intermediate band.

Fig. 14 also illustrates a fitting curve for each set of $r_a$ and $r_b$. This fitting curve is expressed by:

$$\text{(Equation 1)} \qquad 3.2 \ln(r_a) + r_b = 8.9$$

The set of $r_a$ and $r_b$ in Fig. 14 is the threshold value for forming the intermediate band. Therefore, it was found that the intermediate band was formed in the in-plane direction of the quantum dot layers with $r_a$ and $r_b$ satisfying:

$$\text{(Equation 2)} \qquad 3.2 \ln(r_a) + r_b \ \leq \ 8.9$$

[Calculation example 2]

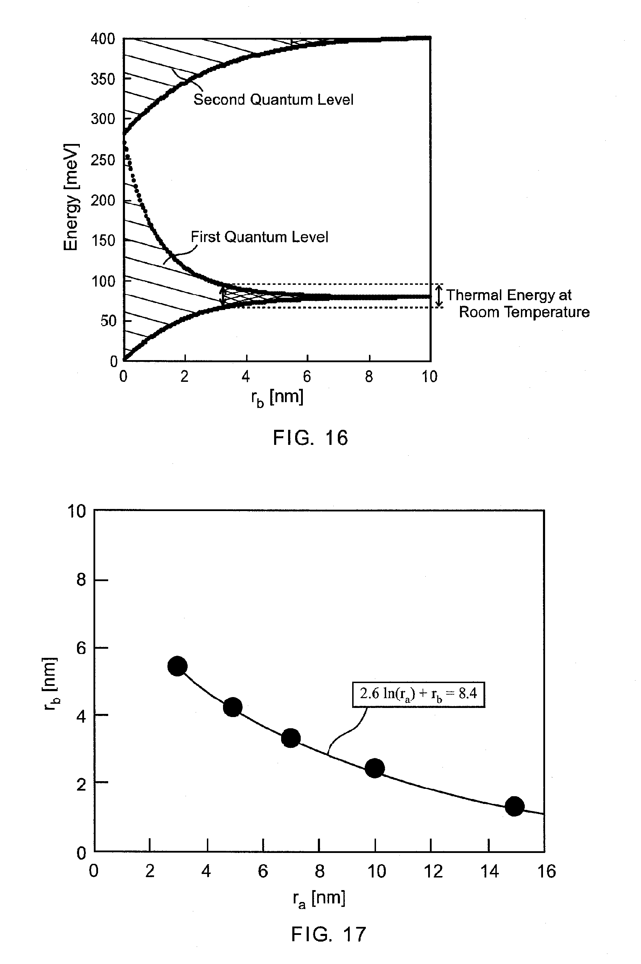

The condition for forming the band in the in-plane direction of the quantum dot layers was calculated, in the case of x = 0.9.
In the case of x = 0.9, the parameters were such that $m_a{}^* = 0.0274m_0$, $m_b{}^* = 0.067m_0$, and V = 0.655 eV.
The relational expression for $r_a$ and $r_b$ in this case was derived as described below as in the calculation example 1.
Firstly, the quantum level energy for $r_b$ in the conduction band in the case of $r_a$ = 3 nm was calculated. Fig. 15 illustrates the result.
A shaded area in Fig. 15 has a finite intermediate-band width, wherein the intermediate band is formed in a hatched stripe area. An energy width indicated by an arrow in the shaded area corresponds to the thermal energy at room temperature that is 26 meV. Therefore, if $r_b$ is smaller than the value pointing the arrow, the intermediate band is formed. It was found that, in the case of $r_a$ = 3 nm, the intermediate band of the first quantum level was formed if $r_b$ was smaller than 5.4 nm.
Similarly, the quantum level energy in the conduction band in case where $r_a$ was 7 nm, and $r_b$ was varied from 0 to 10 was calculated. Fig. 16 illustrates the result. In this case, it was found that the intermediate band of the first quantum level was formed if $r_b$ was smaller than 3.3 nm.
In this way, the similar calculation was executed to various values of $r_a$. Fig. 17 is a graph in which sets of $r_a$ and $r_b$ are plotted, each set being a threshold value for forming the intermediate band.
Fig. 17 also illustrates a fitting curve for each set of $r_a$ and $r_b$. This fitting curve is expressed by:

$$\text{(Equation 3)} \qquad 2.6 \ln(r_a) + r_b = 8.4$$

The set of $r_a$ and $r_b$ in Fig. 17 is the threshold value for forming the intermediate band. Therefore, it was found that the intermediate band was formed in the in-plane direction of the quantum dot layers with $r_a$ and $r_b$ satisfying:

$$\text{(Equation 4)} \qquad 2.6 \ln(r_a) + r_b \ \leq \ 8.4$$

[Calculation example 3]

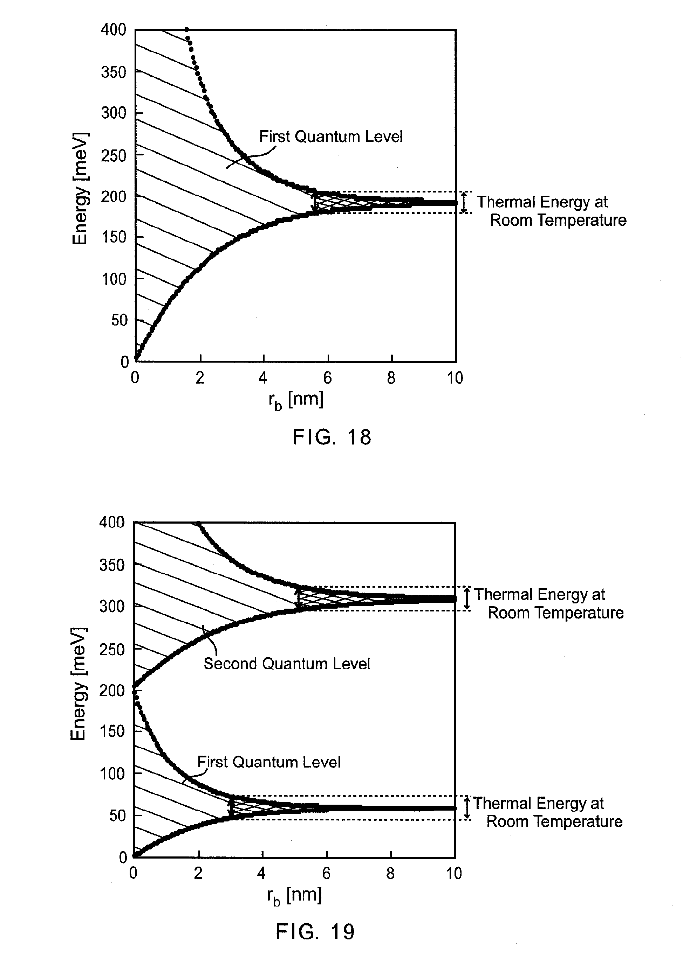

The condition for forming the band in the in-plane direction of the quantum dot layers was calculated, in the case of x = 1.0. In the case of x = 1.0, the quantum dot layers are formed by using GaAs for the barrier layers and InAs for the quantum dots.
In the case of x = 0.1, the parameters were such that $m_a{}^* = 0.023m_0$, $m_b{}^* = 0.067m_0$, and V = 0.697 eV.
The relational expression for $r_a$ and $r_b$ in this case was derived as described below as in the calculation example 1.
Firstly, the quantum level energy for $r_b$ in the conduction band in the case of $r_a$ = 3 nm was calculated. Fig. 18 illustrates the result.
A shaded area in Fig. 18 has a finite intermediate-band width, wherein the intermediate band is formed in a hatched stripe area. An energy width indicated by an arrow in the shaded area corresponds to the thermal energy at room temperature that is 26 meV. Therefore, if $r_b$ is smaller than the value pointing the arrow, the intermediate band is formed. It was found that, in the case of $r_a$ = 3 nm, the intermediate band of the first quantum level was formed if $r_b$ was smaller than 5.6 nm.
Similarly, the quantum level energy in the conduction band in case where $r_a$ was 9 nm, and $r_b$ was varied from 0 to 10 was calculated. Fig. 19 illustrates the result. In this case, it was found that the intermediate band of the first quantum level was formed if $r_b$ was smaller than 3.0 nm.

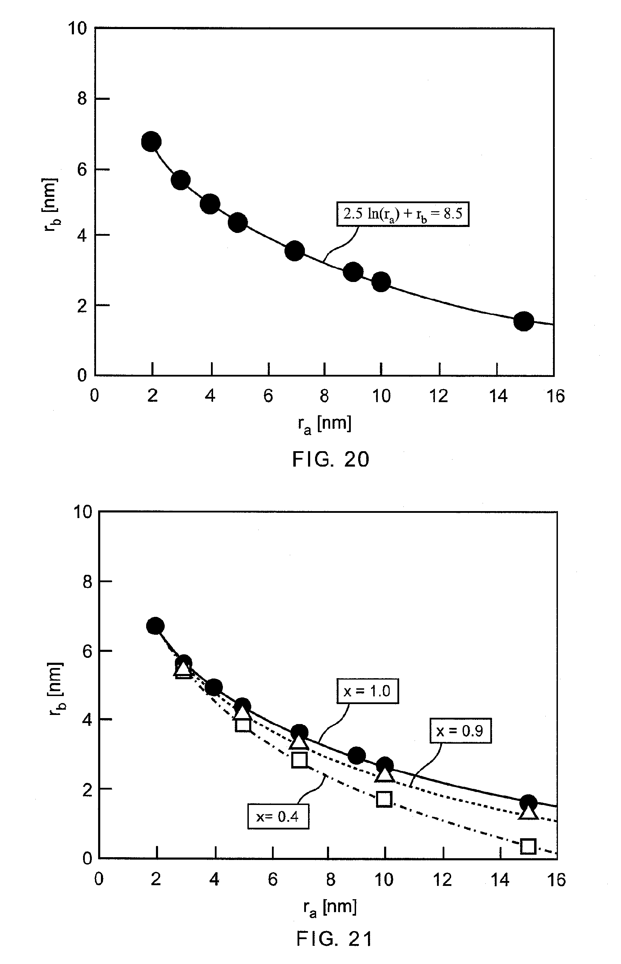

In this way, the similar calculation was executed to various values of $r_a$. Fig. 20 is a graph in which sets of $r_a$ and $r_b$ are plotted, each set being a threshold value for forming the intermediate band.

Fig. 20 also illustrates a fitting curve for each set of $r_a$ and $r_b$. This fitting curve is expressed by:

$$\text{(Equation 5)} \qquad 2.5\ \ln(r_a) + r_b = 8.5$$

The set of $r_a$ and $r_b$ in Fig. 20 is the threshold value for forming the intermediate band. Therefore, it was found that the intermediate band was formed in the in-plane direction of the quantum dot layers with $r_a$ and $r_b$ satisfying:

$$\text{(Equation 6)} \qquad 2.5\ \ln(r_a) + r_b \ \ \leq \ \ 8.5$$

The relational expression for $r_a$ and $r_b$ can be unified in the equation 7 described below, as a result of the calculation, as in the calculation examples 1 to 3, in which x was changed in the range of $0.4 \leq x \leq 1$ when GaAs was used for the barrier layers and $In_xGa_{1-x}As$ was used for the quantum dots.

$$\text{(Equation 7)} \qquad A\ln(r_a) + r_b \leq B$$

In this equation, A is a positive real number not more than 3.2, and B is a positive real number not more than 8.9.

Fig. 21 is a graph in which the threshold values of $r_a$ and $r_b$ for forming the band for x = 0.4, 0.9, and 1.0 are plotted.

Although Fig. 21 only illustrates the cases of x = 0.4, 0.9, and 1.0, the threshold curves are present between two curves of x = 0.4 and x = 1.0 within the range of $0.4 \leq x \leq 1$. Therefore, within the range of $0.4 \leq x \leq 1$, the intermediate band is formed with all $r_a$ and $r_b$ corresponding to the region below the threshold curve of x = 0.4.

The threshold curves are present between two curves of x = 0.9 and x = 1.0 within the range of $0.9 \leq x \leq 1.0$. Therefore, within the range of $0.9 \leq x \leq 1.0$, the intermediate band is formed with all $r_a$ and $r_b$ corresponding to the region below the threshold curve of x = 0.9.

In the case of x = 1.0, the intermediate band is formed with all $r_a$ and $r_b$ corresponding to the region below the threshold curve of x = 1.0.

The case where $r_a$ is not more than 2 nm is not considered in the present invention. This is because a formation of a quantum dot smaller than 2 nm is technically very difficult, which means that 2 nm is not a realistic size for the quantum dot.

<u>Simulation experiment 2 for solar cell according to second embodiment</u>

Simulation experiments using simulation software MATLAB based upon Kronig-Penny model were carried out for checking the formation of the intermediate band, wherein the material for the quantum dots, the material for the barrier layers, the diameter $r_a$ of the quantum dot in the in-plane direction of the quantum dot layers, and the space $r_b$ between two adjacent quantum dot were set.

The simulation experiments use the diameter $r_a$ of the quantum dot 25 in the in-plane direction of the quantum dot layers 30, the space rb between two adjacent quantum dots 25, and the difference V between the energy level at the bottom of the conduction band of the material for the barrier layers and the energy level at the bottom of the conduction band of the material for the quantum dots, these parameters being illustrated in Figs. 9A and 9C. In this simulation, $r_{a+b}$ that is the sum of $r_a$ and $r_b$ is defined as a distance of one cycle in the calculation. This simulation was performed under the periodic boundary condition based upon this cycle.

[Calculation example 4]

The simulation experiment was carried out, wherein InAs (x = 1) was used for the material of the quantum dots 25, GaAs was used for the material of the barrier layers 26, the diameter $r_a$ of the quantum dot 25 was set to be 5 nm, and the space $r_b$ between the quantum dots 25 was set to be 4 nm.

In this calculation example, $r_a$ = 5 nm and $r_b$ = 4 nm were substituted into Kronig-Penny model respectively.

$0.0274m_0$ that is the effective mass of the quantum dots 25 in the conduction band in these materials, $0.067m_0$ that is the effective mass of the barrier layers 41 in the conduction band, and 0.697 eV that is the difference V between the energy level of the quantum dots 25 in the conduction band and the energy level of the barrier layers 26 in the conduction band were respectively substituted into the Kronig-Penny model.

It was found from the calculation that the width of the intermediate band was 34 meV, and hence, the intermediate band was formed in the in-plane direction of the quantum dot layers.

It was also found that, in this case, $2.6 \ln(r_a) + r_b$ was 8.18 that was not more than 8.9.

[Calculation example 5]

The simulation experiment was carried out, wherein $In_{0.4}Go_{0.6}As$ (x = 0.4) was used for the material of the quantum dots 25, GaAs was used for the material of the barrier layers 26, the diameter $r_a$ of the quantum dot 25 was set to be 7 nm, and the space $r_b$ between the quantum dots 25 was set to be 2 nm.

In this calculation example, $r_a$ = 7 nm and $r_b$ = 2 nm were substituted into Kronig-Penny model respectively. $0.0494m_0$ that is the effective mass of the quantum dots 25 in the conduction band in these materials, $0.067m_0$ that is the effective mass of the barrier layers 26 in the conduction band, and 0.353 eV that is the difference V between the energy level of the quantum dots 25 in the conduction band and the energy level of the barrier layers 26 in the conduction band were respectively substituted into the Kronig-Penny model.

It was found from the calculation that the width of the intermediate band was 44 meV, and hence, the intermediate band was formed in the in-plane direction of the quantum dot layers.

It was also found that, in this case, $3.2 \ln(r_a) + r_b$ was 7.06 that was not more than 8.4.

[Calculation example 6]

The simulation experiment was carried out, wherein $In_{0.4}Ga_{0.4}As$ (x = 0.6) was used for the material of the quantum dots 25, GaAs was used for the material of the barrier layers 26, the diameter $r_a$ of the quantum dot 25 was set to be 10 nm, and the space $r_b$ between the quantum dots 25 was set to be 1.5 nm.

In this calculation example, $r_a$ = 10 nm and $r_b$ = 1.5 nm were substituted into Kronig-Penny model respectively. $0.0406m_0$ that is the effective mass of the quantum dots 25 in the conduction band in these materials, $0.067m_0$ that is the effective mass of the barrier layers 26 in the conduction band, and 0.493 eV that is the difference V between the energy level of the quantum dots 25 in the conduction band and the energy level of the barrier layers 26 in the conduction band were respectively substituted into the Kronig-Penny model.

It was found from the calculation that the width of the intermediate band was 34 meV, and hence, the intermediate band was formed in the in-plane direction of the quantum dot layers.

It was also found that, in this case, $3.2 \ln(r_a) + r_b$ was 8.86 that was not more than 8.9, and $2.6 \ln(r_a) + r_b$ was 7.46 that was not more than 8.4.

Since the quantum dot layer has the above-mentioned structure, the carriers can move in the in-plane direction of the quantum dot layers. In the superlattice semiconductor layer formed by employing the quantum dot layers having formed therein the intermediate band in the in-plane direction as described above, the carriers have a degree of freedom in a three-dimensional manner. Therefore, the carriers, which are conventionally trapped by the carrier trap such as the defect because they can move only in the stacking direction, can also move in the in-plane direction. Accordingly, the carriers can be transferred in the direction of avoiding the trap due to the phonon scattering. Specifically, the quantum dot intermediate-band solar cell according to the present invention can increase the number of carriers that can reach the electrode, out of the carriers generated in the superlattice semiconductor layer, whereby the current value of the solar cell can be increased.

**Claims**

1. A solar cell comprising a p-type semiconductor layer, an n-type semiconductor layer, and a superlattice semiconductor layer interposed between the p-type semiconductor layer and the n-type semiconductor layer, wherein the superlattice semiconductor layer has a stacked structure in which quantum layers and barrier layers are stacked alternately and repeatedly, wherein the stacked structure is formed whereby a miniband is formed by a quantum level of the quantum layers on the side of a conduction band, wherein an energy level at a bottom of the miniband is lower than an energy level at a bottom of the conduction band of the barrier layers, and an energy level at a top of the miniband is higher than an energy level, which is lower than the energy level at the bottom of the conduction band of the barrier layers by an amount twice as much as thermal energy kT (k: Boltzmann constant, T: absolute temperature) at room temperature.

**2.** The solar cell according to claim 1, wherein the energy level at the top of the miniband is higher than the energy level at the bottom of the conduction band of the barrier layers.

**3.** The solar cell according to claim 1 or 2, wherein the superlattice semiconductor layer is formed whereby only one miniband is formed by the quantum level of the quantum layers on the side of the conduction band.

**4.** The solar cell according to any one of claims 1 to 3, wherein the p-type semiconductor layer, the n-type semiconductor layer, and the superlattice semiconductor layer form a p-n junction or p-i-n junction.

**5.** The solar cell according to any one of claims 1 to 4, wherein the quantum layers are quantum dot layers each comprising a plurality of quantum dots.

**6.** The solar cell according to any one of claims 1 to 5, wherein the superlattice semiconductor layer is made of a group III-V compound semiconductor, a group II-VI compound semiconductor or a chalcopyrite semiconductor.

**7.** The solar cell according to any one of claims 1 to 6, wherein the superlattice semiconductor layer is made of a group III-V compound semiconductor including at least one element of Al, Ga and In, and at least one element of As, Sb and P.

**8.** A solar cell comprising a p-type semiconductor layer, an n-type semiconductor layer, and a superlattice semiconductor layer interposed between the p-type semiconductor layer and the n-type semiconductor layer, wherein the superlattice semiconductor layer has a stacked structure in which barrier layers and quantum dot layers, each quantum dot layer comprising quantum dots surrounded by the barrier layers, are stacked alternately and repeatedly, wherein the stacked structure is formed whereby an intermediate band is formed in both a thickness direction of the superlattice semiconductor layer and a direction orthogonal to the thickness direction of the superlattice semiconductor layer.

**9.** The solar cell according to claim 8, wherein the stacked structure is formed whereby the intermediate band is formed in the direction orthogonal to the thickness direction of the superlattice semiconductor layer by the first quantum level of the quantum dots.

**10.** The solar cell according to claim 8 or 9, wherein the barrier layers are made of GaAs, and the quantum dot layers are made of $In_xGa_{1-x}As$ ($0 \leq x \leq 1$).

**11.** The solar cell according to claim 10, wherein the quantum dot layers satisfy $3.2 \ln(r_a) + r_b$ is 8.9 or less, wherein: $r_a$ is a diameter of each of the quantum dots in the direction orthogonal to the thickness direction of the superlattice semiconductor layer; and $r_b$ is a distance between two adjacent quantum dots in the direction orthogonal to the thickness direction of the superlattice semiconductor layer.

**12.** The solar cell according to claim 10, wherein the quantum dot layers satisfy $2.6 \ln(r_a) + r_b$ is 8.4 or less, wherein: $r_a$ is a diameter of each of the quantum dots in the direction orthogonal to the thickness direction of the superlattice semiconductor layer; and $r_b$ is a distance between two adjacent quantum dots in the direction orthogonal to the thickness direction of the superlattice semiconductor layer.

FIG. 1

FIG. 2

FIG. 3

FIG. 4

23

FIG. 5

FIG. 6

FIG. 7

FIG. 8

FIG. 9A

FIG. 9B

FIG. 9C

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22A

FIG. 22B

FIG. 23A

FIG. 23B

FIG. 23C

FIG. 24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011104591 A
- JP 2011115876 A
- JP 2010509772 W

**Non-patent literature cited in the description**

- *Physical Review Letters,* 2006, vol. 97, 247701
- *JOURNAL OF APPLIED PHYSICS,* 2001, vol. 89, 5509
- *JOURNAL OF APPLIED PHYSICS,* vol. 89, 5509, 1002